# EUROPÄISCHE PATENTANMELDUNG

(11) **EP 4 027 200 A1**
(43) Veröffentlichungstag der Anmeldung: **13.07.2022**
(21) Anmeldenummer: 22155708.5
(22) Anmeldetag: 07.12.2018
(51) Int. Cl.: G03F 7/20, B41C 1/10

(54) **VERFAHREN ZUR KENNZEICHNUNG EINES RELIEFVORLÄUFERS ZUR HERSTELLUNG EINER RELIEFSTRUKTUR**

(30) Priorität: 08.12.2017 EP 17206168
(62) Teilanmeldung aus: 18816029.5
(71) Anmelder: Flint Group Germany GmbH, 70469 Stuttgart (DE)
(72) Erfinder: MUEHLFEIT, Markus, 71263 Weil der Stadt (DE); BICKERT, Timo, 23858 Barnitz (DE); LENNICK, Ruediger, 71686 Remseck (DE); KNAPP, Andrew, Charlotte, NC 28273 (US)
(74) Vertreter: Arnold & Siedsma

(57) **Zusammenfassung**

Verfahren zur Kennzeichnung eines Reliefvorläufers umfassend einen Träger und eine reliefbildende Schicht mit den Schritten:
a) Bereitstellung eines Reliefvorläufers umfassend einen Träger und eine reliefbildende Schicht;
b) Bereitstellung von Daten, welche den Typ des Reliefvorläufers kennzeichnen und/oder gegebenenfalls prozessrelevante Daten für dessen Verarbeitung enthalten, in Form mindestens eines zweidimensionalen Codes;
c) Einbringen des mindestens einen Codes als Relief in die reliefbildende Schicht.

## Beschreibung

Die Erfindung betrifft ein Verfahren zur Kennzeichnung eines Reliefvorläufers, insbesondere eines Druckplattenvorläufers, ein Verfahren zur Herstellung eines Reliefs, insbesondere einer Druckplatte, ausgehend von dem Reliefvorläufer, sowie das Relief und dessen Verwendung.

Reliefvorläufer bestehen im Allgemeinen aus einer Trägerschicht und einer lichtempfindlichen Schicht sowie weiteren Schichten. Das Relief wird in der Regel dadurch erzeugt, dass die lichtempfindliche Schicht durch Belichten so verändert wird, dass in einem nachfolgenden Schritt die unbelichteten Bereiche entfernt werden können. Reliefvorläufer werden in einer Vielzahl von Varianten angeboten und verwendet, so können sie sich beispielsweis in der Schichtdicke, der Reaktivität, der Zahl und Art von Schichten, der Härte und weiteren Eigenschaften unterscheiden. Das macht die Verarbeitung der Reliefvorläufer anfällig für Verwechslungen und Fehlproduktionen, wenn sie mit falschen Prozessparametern verarbeitet oder falsche Daten verwendet werden.

Um Verwechslungen entgegenzuwirken, werden verschiedene Vorläufertypen unterschiedlich eingefärbt. Die EP 1 679 549 B1 beschreibt beispielsweise den Einsatz von Lumineszenzfarbstoffen zu diesem Zweck. Dieser Farbcode beinhaltet jedoch keine weiteren Informationen über die Eigenschaften der Reliefvorläufer.

Eine andere Möglichkeit ist das Anbringen von Kennzeichnungen auf oder zwischen den einzelnen Schichten der Reliefvorläufer. Beschriftungen mit Tinten oder Etiketten haben sich als nicht praktikabel erwiesen, da diese die Prozessschritte zur Herstellung der Reliefstrukturen nicht unbeschadet überstehen. JP-H 11133590 A beschreibt das Anbringen einer Markierung auf einem Schutzfilm auf der Oberseite des Reliefvorläufers. Da dieser Film in der Regel vor der Verarbeitung entfernt wird, steht die Information während der Verarbeitung nicht mehr zur Verfügung.

EP 2 722 713 A2 beschriebt das Einbringen einer Kodierung zwischen der Trägerfolie und der lichtempfindlichen Schicht des Reliefvorläufers. Diese Kodierung bleibt auch in den nachfolgenden Prozessschritten erhalten, es ist jedoch aufwändig, diese Schicht herzustellen und dafür zu sorgen, dass die Kodierung die anderen Prozessschritte nicht beeinflusst und trotzdem gut lesbar ist. Bei Reliefvorläufern, in die eine Maskenschicht integriert ist, lässt sich die Kodierung aufgrund der hohen Absorption der Maskenschicht nicht lesen.

In US 9,375,916 wird vorgeschlagen, eine Markierung auf der Rückseite der Trägerschicht oder in den Vertiefungen des Reliefs anzubringen, um mit deren Hilfe eine Ausrichtung (Registrierung) in den nachfolgenden Schritten zu gewährleisten. Hier wird die Markierung jedoch erst nach der Erzeugung des Reliefs angebracht und kann damit Prozessfehler während der Relieferzeugung nicht verhindern.

JP2000181051 beschreibt schlägt ebenfalls vor, eine Markierung in den Vertiefungen des Reliefs anzubringen, um die Reliefstruktur nach mehrmaligem Gebrauch und bei der Lagerung identifizieren zu können. Jedoch erfordert dies die Erzeugung einer zusätzlichen Maske und einen zusätzlichen Belichtungsschritt, was das Verfahren kompliziert und langwierig macht.

Es ist deshalb Aufgabe der Erfindung, ein Verfahren zur dauerhaften Kennzeichnung eines Reliefvorläufers zur Verfügung zu stellen, das die beschriebenen Nachteile nicht aufweist, und das eine dauerhafte Codierung von Daten, das Auslesen und Verwenden derselben zur Prozesssteuerung erlaubt.

Gelöst wird die Aufgabe durch ein Verfahren zur Kennzeichnung eines Reliefvorläufers oder eines Reliefs umfassend einen Träger und eine reliefbildende Schicht mit den Schritten:
a) Bereitstellung eines Reliefvorläufers umfassend einen Träger und eine reliefbildende Schicht;
b) Bereitstellung von Daten, welche den Typ des Reliefvorläufers oder Reliefs kennzeichnen und gegebenenfalls Prozessparameter für dessen Verarbeitung enthalten, in Form mindestens eines zweidimensionalen Codes;
c) Einbringen des zweidimensionalen Codes als Relief in die reliefbildende Schicht.

Erfindungsgemäß wird ein zweidimensionaler Code während der bildhaften Strukturierung des Reliefvorläufers erzeugt und bleibt anschließend als dreidimensionales Relief erhalten. Durch Auslesen der in 2- oder 3-dimensionaler Form codierten Daten und Datentransfer kann der Herstellungsprozess gesteuert werden. Der Code lässt sich maschinell, bevorzugt berührungslos, auslesen.

In Schritt a) wird ein Reliefvorläufer zur Verfügung gestellt, der einen dimensionsstabilen Träger und eine reliefbildende Schicht umfasst. Als Träger können dimensionsstabile Trägermaterialien eingesetzt werden, die optional weitere Schichten aufweisen können. Beispiele geeigneter dimensionsstabiler Träger sind Platten, Folien sowie konische und zylindrische Röhren (Sleeves) aus Metallen wie Stahl, Aluminium, Kupfer oder Nickel oder aus Kunststoffen wie Polyethylenterephthalat, Polybutylenterephthalat, Polyamid und Polycarbonat, Geweben und Vliesen, wie Glasfasergewebe, sowie Verbundmaterialien aus Glasfasern und Kunststoffen. Als dimensionsstabile Träger kommen insbesondere dimensionsstabile Trägerfolien oder Metallbleche, beispielsweise Polyethylen- oder Polyesterfolien, Stahl- oder Aluminiumbleche in Frage. Diese Trägerfolien oder Bleche sind im Allgemeinen 50 bis 1100 µm, vorzugsweise 75 bis 400 um, beispielsweise ca. 250 µm dick. Wird eine Kunststofffolie verwendet, liegt deren Dicke im Allgemeinen im Bereich von 100 bis 200 um, bevorzugt von 125 bis 175 µm. Wird Stahl als Trägermaterial verwendet, sind Stahlbleche mit einer Dicke von 0,05 bis 0,3 mm bevorzugt. Zum Schutz gegen Korrosion werden bevorzugt verzinnte Stahlbleche verwendet. Diese Trägerfolien oder Trägerbleche können mit einer dünnen haftvermittelnden Schicht, beispielsweise einer 0,05 bis 5 um dicken Schicht, auf der der Substratschicht zugewandten Seite der Trägerfolie beschichtet sein.

Zusätzliche haftungsverbessernde Zwischenschichten können sich auf der von der Trägerschicht abgewandten Seite der Haftschicht befinden, weisen Schichtdicken zwischen 0,1 und 50 µm, insbesondere 1 und 10 um auf.

Der Reliefvorläufer umfasst mindestens eine reliefbildende Schicht. Die reliefbildende Schicht kann unmittelbar auf dem Träger aufgebracht sein. Zwischen dem Träger und der reliefbildenden Schicht können sich aber auch noch andere Schichten befinden, wie beispielsweise Haftschichten oder elastische oder kompressible Unterschichten.

Die reliefbildende Schicht kann auch aus mehr als einer Schicht bestehen, wobei sie im Allgemeinen 2 bis 20 Schichten, vorzugsweise 2 bis 5 Schichten, besonders bevorzugt 2 bis 3 Schichten, ganz besonders bevorzugt eine Schicht umfasst. Die Schichten können die gleichen Bestandteilen oder unterschiedliche Bestandteile enthalten und dies in gleichen oder unterschiedlichen Anteilen. Vorzugsweise enthalten diese Schichten die gleichen Bestandteile. Vorzugsweise sind die reliefbildenden Schichten, die der Trägerschicht am nächsten liegen, bereits fixiert, vernetzt und/oder abreagiert. Auf diesen fixierten, vernetzten, abreagierten Schichten ist mindestens eine reliefbildende Schicht angeordnet, die noch fixiert, vernetzt werden oder abreagieren kann.

Die Dicke der reliefbildenden Schicht beträgt im Allgemeinen 0,1 mm bis 7 mm, bevorzugt 0,5 mm bis 4 mm, besonders bevorzugt 0,7 mm bis 3 mm und ganz besonders bevorzugt 0,7 mm bis 2,5 mm. In einigen Fällen ist die Schichtdicke bevorzugt von 2 mm bis 7 mm besonders bevorzugt von 2,5 mm bis 7 mm und ganz besonders bevorzugt von 2,8 mm bis 7 mm.

Optional kann der Reliefvorläufer weitere Schichten umfassen. Beispielsweise können sich auf der reliefbildenden Schicht eine oder mehrere funktionale Schichten befinden. Die funktionalen Schichten können beispielsweise eine Schutzfunktion, eine Maskenfunktion, eine Barrierefunktion, eine Strukturierungsfunktion, eine Haftungs- oder Trennfunktion oder Kombinationen davon aufweisen. Diese funktionalen Schichten können in einem vorgelagerten Schritt oder während der Verarbeitung ganz oder teilweise entfernt werden oder aber dauerhaft vorhanden sein. Beispielsweise kann eine Schutzschicht vorhanden sein, die die reliefbildende Schicht vor Verschmutzung und Beschädigung schützt. Diese wird im Allgemeinen vor dem Einbringen des Codes entfernt.

Durch entsprechende Tests werden die Daten, die zur Identifizierung und weiteren Verarbeitung der Reliefvorläufer benötigt werden, erhoben und entweder in analoger oder digitaler Form als mindestens zweidimensionaler Code zur Verfügung gestellt. Dieser zweidimensionale Code kann beispielsweise in oder an der Verpackung der Reliefvorläufer oder dem Reliefvorläufer selbst angebracht sein, beispielsweise als Etikett oder RFID-Code, oder auf den Lieferpapieren oder anderen Unterlagen aufgedruckt sein. Diese Daten umfassen Daten zum Typ des Reliefvorläufers und gegebenenfalls prozessrelevante Daten oder Bereiche derselben, die zur Erzeugung eines Reliefs oder einer funktionierenden Druckplatte nötig sind. Daten zum Typ des Reliefvorläufers umfassen beispielsweise eine Artikelnummer, eine Chargennummer, eine Identifikationsnummer, Angaben zur Dicke der Platte oder einer Schicht, Angaben zur Länge und Breite des Reliefvorläufers, Plattentyp oder beliebige Kombinationen davon. Daten zu Prozessparametern sind beispielsweise Belichtungsbedingungen, Ablationsbedingungen, Temperaturbedingungen, Reinigungsbedingungen, Entwicklungsbedingungen, Trocknungsbedingungen, Lagerbedingungen, Gerätekonfigurationen und Einstellungen, Priorität im Prozessablauf und beliebige Kombinationen davon. Prozessrelevante Daten können auch Nachrichten oder Hinweise an den Operator beinhalten und beispielsweise eine Warnung, eine Eingabeaufforderung, eine Aufforderung zur Überprüfung von Parametern oder Geräteeinstellungen oder Gerätezuständen, Anweisungen und Informationen bezüglich der nächsten Prozessschritte oder Kombinationen davon sein. Ebenso können die Daten zum Typ und zu den Prozessbedingungen in beliebiger Weise kombiniert werden. Weiterhin kann der Code bei einer Eingangskontrolle, beim Versand, beim Einsatz am richtigen Ort in der Druckmaschine und zur Identifizierung des Reliefvorläufers Verwendung finden.

In Schritt c) wird dieser Code als Relief in die reliefbildende Schicht eingebracht, wozu es mehrere Möglichkeiten gibt. Das Relief kann als Erhebungen auf einem Sockel oder als Vertiefungen in einer Schicht ausgebildet sein. Nach der Erzeugung des Reliefs ist der Code fest und dauerhaft auf dem Vorläufer verankert und damit für alle nachfolgenden Schritte dauerhaft verfügbar und auslesbar. Das Relief, das den Code enthält, kann in nachfolgenden Schritten ohne mutwillige mechanische Entfernung nicht verlorengehen (andere Markierungen, wie beispielsweise aufgeklebten Identifizierungen, können beispielsweise in Entwicklungsbädern abgelöst werden). Nach der Erzeugung des Reliefs liegt der Code in dreidimensionaler Form vor, wobei die Höhe des Reliefs, die durch den mittleren Abstand der Oberfläche der Erhebungen zu der Oberfläche der Vertiefungen definiert ist, in einem Bereich von 0,01 µm bis zu 10 mm, bevorzugt im Bereich von 0,1 µm bis zu 10 mm, besonders bevorzugt im Bereich von 1 µm bis 7 mm und ganz besonders bevorzugt im Bereich von 2 um bis zu 5 mm liegt. Der Code kann an einer beliebigen Stelle des Reliefvorläufers angebracht werden, vorzugsweise wird er in Bereichen angebracht, die bei der späteren Verwendung nicht stören, abgeschnitten werden oder nicht zum Einsatz kommen. Dies ist im Allgemeinen in Randbereichen der Fall. Der oder die Codes können aber auch an einer oder mehreren beliebigen Stellen platziert werden, was besonders dann vorteilhaft ist, wenn das Relief in mehrere Teile aufgeteilt wird. Hier kann ein für das entsprechende Teil maßgeschneiderter Code angebracht werden.

In einer Ausführungsform des erfindungsgemäßen Verfahrens ist die reliefbildende Schicht eine gravierbare Schicht, und wird in Schritt c) der zweidimensionale Code als Relief durch materialabtragende Methoden in die reliefbildende Schicht eingebracht. Eine gravierbare Schicht umfasst im Allgemeinen Materialien, die sich mechanisch abtragen lassen oder durch energiereiche Strahlung zersetzen und/oder verflüchtigen lassen. Das können sowohl anorganische oder organische Materialien oder Kombinationen davon sein. Vorzugsweise werden organische Materialen eingesetzt. Zusätzlich kann die reliefbildende Schicht Stoffe enthalten, die die Strahlung absorbieren und vorzugsweise in Wärme umwanden. Dazu gehören beispielsweise Pigmente und Farbstoffe, die im entsprechenden Wellenlängenbereich absorbieren. Als elektromagnetische Strahlung zum Eingravieren des Reliefs wir in der Regel Strahlung mit einer Wellenlänge im Bereich von 300 nm bis 20000 nm, bevorzugt im Bereich von 500 nm bis 20 000 nm, besonders bevorzugt im Bereich von 800 nm bis 15 000 nm, ganz besonders bevorzugt im Bereich von 800 nm bis 11 000 nm verwendet. Neben Festkörperlasern kommen auch Gaslaser oder Faserlaser zum Einsatz. Vorzugsweise kommen bei der Lasergravur Nd:YAG-Laser (1064 nm) oder CO2-Laser (9400 nm und 10600 nm) zum Einsatz. Zur selektiven Entfernung der Reliefschicht werden dabei ein oder mehrere Laserstrahlen so gesteuert, dass das gewünschte Druckbild und der Code erzeugt werden.

In diesem Fall kann der Code neben Angaben zum Typ (Artikelnummer, Chargenummer, Identifikationsnummer, Angaben zur Dicke der Druckplatte oder einer Schicht, Angaben zur Länge und Breite, Typ) auch Daten zu den Bedingungen weiterer Prozessschritte umfassen. Beispiele für weitere Prozessschritte sind eine thermische Nachbehandlung zur Verbesserung der mechanischen Eigenschaften, eine Reinigungsbehandlung zur Entfernung von Rückständen der Gravur oder eine Planarisierung. Bei einer thermischen Nachbehandlung können die Daten beispielsweise Angaben zur Temperatur, dem Temperaturverlauf und der Dauer der Nachbehandlung umfassen. Im Falle einer Reinigung der Druckplatte als weiterem Prozessschritt können die Daten beispielsweise Angaben zum Reinigungsmittel, zur Reinigungsart, zur Temperatur zu Umgebungsbedingungen (Druck, Atmosphäre, Staubklasse etc.) und Dauer der Reinigung umfassen.

In einer weiteren Ausführungsform des erfindungsgemäßen Verfahrens ist die reliefbildende Schicht eine fotoempfindliche Schicht, und wird in Schritt c) der zweidimensionale Code durch direkte bildweise Belichtung und nachfolgende Entfernung von belichteten oder unbelichteten Bereichen in die reliefbildende Schicht eingebracht. Fotoempfindlich Schichten umfassen einen Initiator oder ein Initiatorsystem, eine reaktive Verbindung, die durch den Initiator zur Reaktion gebracht wird und gegebenenfalls weitere Komponenten, wie beispielsweise Bindemittel, Additive, farbgebende Mittel und dergleichen. Die ausgelöste Reaktion führt dabei entweder zu einer Verfestigung oder Verringerung der Löslichkeit der belichteten Bereiche der reliefbildenden Schicht oder zu einer Erweichung/Verflüssigung bzw. Erhöhung der Löslichkeit der belichteten Bereiche. Die Unterschiede in Löslichkeit bzw. Festigkeit werden in einem nachfolgenden Entwicklungsschritt durch Entfernung der löslichen bzw. flüssigeren Bereiche zur Erzeugung eines 3-dimensionalen Reliefs genutzt. Vorzugsweise wird eine Verfestigung oder Verringerung der Löslichkeit angestrebt. Dazu eignen sich polymerisierende und/oder vernetzende Reaktionen wie beispielsweise radikalische Reaktionen oder Kondensationsreaktionen. Vorzugsweise werden radikalische Polymerisation und Vernetzung eingesetzt. Diese wiederum kann photochemisch oder thermisch initiiert werden. Bei der fotochemischen Imitierung werden Photoinitiatoren eingesetzt, die bei Belichtung Radikale erzeugen, während bei der thermischen Variante ein thermisch aktivierter Zerfall in Radikale ausgenutzt wird. Vorzugsweise wird die Photoaktivierung eingesetzt. Eine andere Möglichkeit besteht darin, photochemisch Säuren oder Basen zu erzeugen, die eine Vernetzung bzw. Polymerisation starten oder die Löslichkeit verändern. Die Löslichkeit von Polymeren kann beispielsweise durch säure- bzw. basenkatalysierte Abspaltung von Schutzgruppen erhöht werden.

Die reliefbildende Schicht enthält einen oder mehrere Initiatoren oder Initiatorsysteme aus mindestens 2 Komponenten, die bei Erwärmung und/oder Bestrahlung mit elektromagnetischer Strahlung Radikale erzeugen, die eine Polymerisation und/oder Vernetzung bewirken. Derartige Initiatoren sind dem Fachmann bekannt und beispielsweise in folgen-der Literatur beschrieben: Bruce M. Monroe et al., Chemical Review, 93, 435 (1993), R. S. Davidson, Journal of Photochemistry and Biology A: Chemistry, 73, 81 (1993), J. P. Faussier, Photoinitiated Polymerization-Theory and Applications: Rapra Review, Vol. 9, Report, RapraTechnology (1998), M. Tsunooka et al., 25 Prog. Polym. Sci., 21, 1 (1996), F. D. Saeva, Topics in Current Chemistry, 1 56, 59 (1990), G. G. Maslak, Topics in Current Chemistry, 168, 1 (1993), H. B. Shuster et al., JAGS, 112, 6329 (1990) and I. D. F. Eaton et al., JAGS, 102, 3298 (1980), P. Fouassier and J. F. Rabek, Radiation Curing in Polymer Science and Technology, pages 77 to 117 (1993) or K.K. Dietliker, Photoinitiators for free Radical and Cationic Polymerisation, Chemistry & Technology of UV & EB Formulation for Coatings, Inks and Paints, Volume, 3, Sita Technology LTD, London 1991; or R.S. Davidson, Exploring the Science, technology and Applications of U.V. and E.B. Curing, Sita Technology LTD, London 1999. Weitere Initiatoren sind beschrieben in JP45-37377, JP44-86516, US3567453, US4343891, EP109772, EP109773, JP63138345, JP63142345, JP63142346, JP63143537, JP4642363, JP59152396, JP61151197, JP6341484, JP2249 and JP24705, JP626223, JPB6314340, JP1559174831, JP1304453 und JP1152109.

Im Allgemeinen enthält die reliefbildende Schicht den Initiator oder das Initiatorsystem in einer Konzentration im Bereich von 0,1 bis 20 Gew.-% bezogen auf die gesamte Formulierung. Bevorzugte Initiator-Konzentrationen liegen im Bereich von 1 bis 10 Gew.-%, besonders bevorzugt im Bereich von 1 bis 8 Gew.- %, ganz besonders bevorzugt im Bereich von 1 bis 6 Gew.-%.

Die reliefbildende Schicht umfasst weiterhin in bekannter Art und Weise mindestens ein ethylenisch ungesättigtes Monomer, das mit dem oder den Bindemitteln verträglich ist. Bei dem ethylenisch ungesättigten Monomer kann es sich auch um Mischungen von zwei oder mehr unterschiedlichen Monomeren handeln. Geeignete Verbindungen weisen mindestens eine olefinische Doppelbindung auf und sind polymerisierbar. Diese werden daher nachfolgend als Monomere bezeichnet. Als besonders vorteilhaft haben sich Ester oder Amide der Acrylsäure oder Methacrylsäure mit mono- oder polyfunktionellen Alkoholen, Aminen, Aminoalkoholen oder Hydroxyethern und -estern, Ester der Fumar- oder Maleinsäure, Vinylether, Vinylester und Allylverbindungen erwiesen.

Im Allgemeinen sind diese Monomeren bei Raumtemperatur nicht gasförmige Verbindungen. Bevorzugt enthält das ethylenisch ungesättigte Monomer mindestens 2 ethylenisch ungesättigte Gruppen, besonders bevorzugt 2 bis 6 ethylenisch ungesättigte Gruppen, ganz besonders bevorzugt 2 oder mehr ethylenisch ungesättigte Gruppen. Auch Verbindungen mit C-C-Dreifachbindungen können in den strahlungsempfindlichen Gemischen eingesetzt werden. Vorzugsweise handelt es sich bei der ethylenisch ungesättigten Gruppe um mindestens eine Acrylat- und/oder eine Methacrylatgruppe, es können jedoch auch Styrolderivate, Acrylamide, Vinylester und Vinylether zum Einsatz kommen. Das ethylenisch ungesättigte Monomer weist ein Molekulargewicht von im Allgemeinen kleiner als 600 g/mol, bevorzugt kleiner als 450 g/mol, besonders bevorzugt kleiner als 400 g/mol, ganz besonders bevorzugt kleiner als 350 g/mol und insbesondere kleiner als 300 g/mol auf.

In einer Ausführungsform ist das ethylenisch ungesättigte Monomer in einer Konzentration im Bereich von 0,5 bis 60 Gew%, bezogen auf die gesamte Formulierung, bevorzugt im Bereich von 1 bis 50 Gew.-%, besonders bevorzugt im Bereich von1 bis 40 Gew.-%, ganz besonders bevorzugt im Bereich von 2 bis 40 Gew.-% enthalten.

Die reliefbildende Schicht kann außerdem Bindemittel enthalten, die sowohl als inerter Zusatz als auch an der Reaktion beteiligte und zur Verfestigung beitragende Reaktanden vorliegen können. Wenn die Bindemittel an der Reaktion beteiligt sind, tragen sie entsprechende funktionelle Gruppen, wie beispielsweise Doppel- oder Dreifachbindungen oder Gruppen mit einem abstrahierbaren Wasserstoff, z.B. Thiole, Phenole oder Amine.

Elastomere Bindemittel zur Herstellung von reliefbildenden Schichten von Flexodruckelementen sind dem Fachmann bekannt. Als Beispiele seien Styrol-Dien-Blockcopolymere, Naturkautschuk, Polybutadien, Polyisopren, Styrol-Butadien-Kautschuk, Nitril-Butadien-Kautschuk, Butyl-Kautschuk, Styrol-Isopren-Kautschuk, Styrol-Butadien-Isopren-Kautschuk, Polynorbornen-Kautschuk oder Ethylen-Propylen-Dien-Kautschuk (EPDM) genannt. Bevorzugt werden hydrophobe Bindemittel eingesetzt. Derartige Bindemittel sind in organischen Lösemitteln oder deren Gemischen löslich.

Bevorzugt handelt es sich bei dem Elastomer um ein thermoplastisch elastomeres Blockcopolymer aus Alkenylaromaten und 1,3-Dienen. Bei den Blockcopolymeren kann es sich sowohl um lineare, verzweigte oder radiale Blockcopolymere handeln. Üblicher-weise handelt es sich um Dreiblock-Copolymere vom A-B-A-Typ, es kann sich aber auch um Zweiblockpolymere vom A-B-Typ handeln, oder um solche mit mehreren alternierenden elastomeren und thermoplastischen Blöcken, z.B. A-B-A-B-A. Es können auch Gemische zweier oder mehrerer unterschiedlicher Blockcopolymere eingesetzt werden. Die Dien-Einheiten können 1,2- oder 1,4-verknüpft sein. Es können sowohl Blockcopolymere vom Styrol-Butadien- oder vom Styrol-Isopren-Typ, als auch vom Styrol-Butadien- Isopren-Typ eingesetzt werden. Weiterhin einsetzbar sind auch thermoplastisch elastomere Blockcopolymere mit Endblöcken aus Styrol und einem statistischen Styrol-Butadien-Mittelblock. Die Blockcopolymere können auch ganz oder teilweise hydriert sein, wie beispielsweise in SEBS-Kautschuken. Bevorzugte elastomere Bindemittel sind Dreiblock- Copolymere vom Typ A-B-A oder radiale Blockcopolymere vom Typ (AB)n, worin A Styrol und B ein Dien sind, sowie statistische Copolymere und Random- Copolymere aus Styrol und einem Dien.

Bei wässrig entwickelbaren Reliefvorläufern werden wasserlösliche, wasserquellbare, in Wasser dispergierbare oder emulgierbare Polymere eingesetzt. Neben voll oder teilweise hydrolysierten Polyvinylacetaten können Polyvinylalkohole, Polyvinylacetale, Polystyrolsulfonate, Polyurethane, Polyamide (wie sie beispielsweise in EP 0 085 472 oder in DE 1522444 beschrieben) und beliebige Kombinationen davon eingesetzt werden. Beispiele für derartige Polymere sind beschrieben in EP 0 079 514, EP 0 224 164 und EP 0 059 988. Diese Polymere können linear, verzweigt, sternförmig oder dendritisch sein und sowohl als Homopolymer, statistische Copolymere, Blockcopolymere oder alternierende Copolymere vorliegen. Sehr oft sind die genannten Polymeren mit funktionellen Gruppen versehen, die entweder die Löslichkeit erhöhen und/oder an Vernetzungsreaktionen teilnehmen können. Zu diesen Gruppen zählen beispielsweise Carboxy-, SO3-, OH, Thiol-, ethylenisch ungesättigte, (Meth)acrylat-, EpoxidGruppen und beliebige Kombinationen davon.

Bei thermisch vernetzenden Reliefvorläufern sind auch andere Polymere und Zusammensetzungen einsetzbar, die beispielsweise durch radikalische Reaktionen, durch Kondensationsreaktionen oder durch kationische oder anionische Additionsreaktionen verfestigen, vernetzen oder polymerisieren. Bei den Kondensationsreaktionen kommen insbesondere die Veresterung und Urethanbildung zur Anwendung. Epoxide können beispielsweise als kationisch polymerisierende oder vernetzende Materialien eingesetzt werden, die photochemisch oder thermisch aktivierbar sind. Derartige Reaktionen lassen sich mittels Katalysatoren, die dem Fachmann bekannt sind, zusätzlich beschleunigen oder starten.

Die Gesamtmenge an Bindemitteln beträgt im Falle der reliefbildenden Schicht üblicherweise 30 bis 90 Gew.-% bezüglich der Summe aller Bestandteile der reliefbildenden Schicht, bevorzugt 40 bis 85 Gew.-% und besonders bevorzugt 45 bis 85 Gew.-%.

Die reliefbildende Schicht kann weitere Bestandteile enthalten, ausgewählt aus der Gruppe bestehend aus Weichmachern, Lösungsmitteln, weiteren Bindemitteln, farbgebenden Mitteln, Stabilisatoren, Reglern, UV-Absorbern, Dispergierhilfsmitteln, Vernetzern, Viskositätsmodifizierern, Weichmachern, Farbstoffen, Pigmenten, Additiven, oberflächenaktiven Substanzen und beliebige Kombinationen davon. Diese Additive oder Hilfs- und Zusatzstoffe sind im strahlungsempfindlichen Gemisch in einer Gesamtkonzentration im Bereich von 0,001 bis 60 Gew.-%, bezogen auf die gesamte Formulierung, bevorzugt im Bereich von 0,01 bis 50 Gew.-%, besonders im Bereich von 0,1 bis 50 Gew.-%, ganz besonders im Bereich von 1 bis 50 Gew.-%, enthalten. Die einzelnen Additive sind dabei in Konzentrationen von 0,001 bis 40 Gew.-%, bezogen auf die gesamte Formulierung, bevorzugt im Bereich von 0,01 bis 40 Gew.-%, besonders im Bereich von 0,1 bis 40 Gew.-%, ganz besonders im Bereich von 0,1 bis 35 Gew.- %, enthalten.

Die reliefbildende Schicht kann darüber hinaus weitere funktionelle Zusätze enthalten, beispielsweise wie in US 8,808,968 beschrieben geringe Mengen von Phosphiten, Phosphinen, Thioethern und von aminofunktionellen Verbindungen.

Weiterhin kann die reliefbildende Schicht grenzflächenaktive Substanzen wie hydrophobe Wachse oder silikonisierte oder perfluorierte Verbindungen enthalten, wie in US 8,114,566 beschrieben.

Weiterhin können in dem strahlungsempfindlichen Gemisch der reliefbildenden Schicht Inhibitoren gegen die thermische Polymerisation, die keine nennenswerte Eigenabsorption in dem aktinischen Bereich, in dem der Photoinitiator absorbiert, enthalten sein, wie z.B. 2,6-Di-tert.-butyl-p-kresol, Hydrochinon, p-Methoxyphenol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine, wie N-Nitrosodiphenylamin, oder die Salze, beispielsweise die Kalium-, Calcium- oder Aluminiumsalze des N-Nitrosocyclohexylhydroxylamins. Darüber hinaus können auch andere Inhibitoren oder Stabilisatoren eingesetzt werden, wie beispielsweise in A. Valet, Lichtschutzmittel für Lacke, 33ff, Vincentz Verlag Hannover 1996 beschrieben und dabei besonders sterisch gehinderte Phenole und Amine.

Auch geeignete farbgebende Mittel, wie Farbstoffe, Pigmente oder photochrome Zusatze, können in dem strahlungsempfindlichen Gemisch der reliefbildenden Schicht in einer Menge von 0,0001 bis 2 Gew.-%, bezogen auf das Gemisch, enthalten sein.

UV-Absorbern in der reliefbildenden Schicht können ebenfalls Vorteile haben und die Reliefausbildung positiv beeinflussen. Als UV-Absorber geeignete Verbindungen sind beispielsweise in A. Valet, Lichtschutzmittel für Lacke, 20ff, Vincentz Verlag Hannover 1996 beschrieben. Beispiele sind Hydroxyphenyl-benztriazole, Hydroxybenzophenone, Hydroxyphenyl-s-triazine, Oxalanilide, Hydroxyphenylpyrimidine, Salicylsäurederivate und Cyanoacrylate und beliebige Kombinationen davon.

Die direkte bildweise Belichtung kann dadurch erzielt werden, dass die zu vernetzenden Bereiche selektiv belichtet werden. Dies kann beispielsweise erreicht werden mit einem oder mehreren Laserstrahlen, welche entsprechend gesteuert werden, durch die Verwendung von Bildschirmen, bei welchen bestimmte Bildpunkte aktiviert werden, die Strahlung emittieren, durch Verwendung von verfahrbaren LED-Leisten, durch LED-Arrays, bei denen einzelne LEDs gezielt ein- und ausgeschaltet werden, durch die Verwendung von elektronisch steuerbare Masken, bei denen Bildpunkte transparent geschaltet werden, die die Strahlung einer Strahlungsquelle passieren lassen, durch die Verwendung von Projektionssystemen, bei welchen durch entsprechende Orientierung von Spiegeln Bildpunkte mit Strahlung einer Strahlungsquelle belichtet werden, oder Kombinationen davon. Bevorzugt erfolgt die direkte Belichtung mittels gesteuerter Laserstrahlen oder Projektionssystemen mit Spiegeln. Dabei müssen die Absorptionsspektren der Inititatoren oder Initiatorsysteme und die Emissionsspektren der Strahlungsquellen wenigstens teilweise überlappen.

Die Absorptionen der Inititatoren oder Initiatorsysteme liegen dabei im Bereich von 200 nm bis 2000 nm, bevorzugt im Bereich von 250 nm bis 1100 nm, besonders bevorzugt im UV Bereich, ganz besonders bevorzugt im Bereich von 300 nm bis 450 nm.

Die Wellenlänge der elektromagnetischen Strahlung liegt dabei im Bereich von 200 nm bis 20 000 nm, bevorzugt im Bereich von 250 nm bis 1100 nm, besonders bevorzugt im UV-Bereich, ganz besonders bevorzugt im Bereich von 300 nm bis 450 nm. Neben breitbandiger Einstrahlung der elektromagnetischen Strahlung kann es vorteilhaft sein, schmalbandige oder monochromatische Wellenlängenbereiche zu verwenden, wie sie unter Einsatz von entsprechenden Filtern, Lasern oder Light Emitting Diodes (LEDs) erzeugt werden können. In diesen Fällen sind Wellenlängen von 350 nm, 365 nm, 385 nm, 395 nm, 400 nm, 405 nm, 532 nm, 830 nm, 1064 nm (und ca. 5 nm bis 10 nm darüber und/oder darunter), einzeln oder in Kombination, bevorzugt.

Die Entfernung von belichteten oder unbelichteten Bereichen der reliefbildenden Schicht kann je nach Natur der Schichten sowohl mechanisch als auch chemisch durch Behandlung mit Auswaschmitteln, wie beispielsweise organischen Lösungsmitteln, deren Gemischen, Wasser, wässrigen Lösungen oder wässrig-organischen Lösungsmittelgemischen erfolgen, die in der Lage sind, nicht vernetzte Bereiche in der reliefbildenden Schicht zu lösen, zu emulgieren und/oder zu dispergieren, erfolgen.

In diesem Entwicklungsschritt können alle dem Fachmann geläufigen Methoden angewendet werden. Die Lösungsmittel oder deren Gemische, die wässrigen Lösungen als auch die wässrig-organischen Lösungsmittelgemische können Hilfsmittel enthalten, die die Formulierung stabilisieren und/oder die Löslichkeit der Komponenten der nicht vernetzten Bereiche erhöhen. Beispiele für derartige Hilfsmittel sind Emulgatoren, Tenside, Salze, Säuren, Basen, Stabilisatoren, Korrosionsschutzmittel und geeignete Kombinationen davon. Zur Entwicklung mit diesen Lösungen können alle dem Fachmann bekannten Methoden eingesetzt werden, wie beispielsweise Tauchen, Waschen oder Besprühen mit dem Entwicklungsmedium, Bürsten in Anwesenheit von Entwicklungsmedium und geeignete Kombinationen davon. Bevorzugt wird mit neutralen wässrigen Lösungen oder Wasser entwickelt, wobei das Entfernen mittels rotierender Büsten oder einem Plüschflor unterstützt wird. Eine weitere Möglichkeit, die Entwicklung zu beeinflussen, besteht darin, die Temperatur des Entwicklungsmediums zu steuern und beispielswiese durch Erhöhung der Temperatur die Entwicklung zu beschleunigen. In diesem Schritt können auch weitere Schichten, die noch auf der strahlungsempfindlichen Schicht vorhanden sind, entfernt werden, wenn diese Schichten beim Entwickeln abgelöst und im Entwicklermedium ausreichend gelöst und/oder dispergiert werden können.

Bei der Verwendung von organischen Lösungsmitteln werden vorzugsweise solche verwendet, die einen hohen Flammpunkt aufweisen, der über einer Temperatur von 40°C, besonders bevorzugt über 60°C liegt. Der Flammpunkt kann in besonderen Fällen auch über 100°C liegen.

Übliche Auswaschmittel sind beispielsweise in EP 332 070 beschrieben. Im Allgemeinen enthalten diese aliphatische, cycloaliphatische oder aromatische Kohlenwasserstoffe und einen oder mehrere Alkohole. Die meisten im Markt verwendeten Auswaschmittel enthalten unpolare Kohlenwasserstoffe als Hauptkomponente sowie Alkohole mittlerer Polarität in einer Menge von 10 bis 30 Gew.-%. In einigen Fällen werden zusätzlich Terpene und weitere Komponenten eingesetzt, wie beispielsweise in US 2016/0054656 beschrieben.

Bei den wässrigen Auswaschmitteln werden neben Leitungswasser wässrige Lösungen eingesetzt, die weitere Bestandteile wie beispielsweise Dispergatoren, Emulgatoren, Säuren, Basen, Flockungsmittel, Salze enthalten und meist einen pH-Wert >7 aufweisen. Als Dispergatoren und/oder Emulgatoren kommen kationische, anionische oder nicht ionische Substanzen oder Kombinationen davon zum Einsatz. Beispiele für anionische Verbindungen sind Carboxylate wie Natriumlaurat oder Natriumoleat, Schwefelsäureestersalze wie Natriumlaurylsulfat, Natriumcetylsulfat, Natriumoleylsulfat, Alkylsulfonate, Phosphorsäureester oder Blockcoplolymere mit polaren und unpolaren Blöcken.

Als organische und anorganische Säuren können beispielsweis Schwefelsäure, Salpetersäure, Phosphorsäuren, Ameisensäure, Essigsäure, Carbonsäuren, Oxalsäure, Zitronensäure, Maleinsäure oder p-Toluolsulfonsäure eingesetzt werden. Beispiele für Basen sind Alkali- und Erdalkalihydroxide, wie LiOH, KOH, NaOH oder CaOH.

Es werden oft auch Wasser-Lösungsmittel-Gemische eingesetzt, die den Einsatz vom Polymeren erlauben, deren Wasserlöslichkeit geringer ist. Beispiele für Lösungsmittel sind Methanol, Ethanol, Isopropanol, Benzylalkohol, Cyclohexanol, Cellosolve, Glycerin, Polyethylenglykol, Dimethylformamide, Dimethylacetamid und Aceton.

In einer weiteren Ausführungsform erfolgt das Entfernen der reliefbildenden Schicht thermisch, also durch Einbringen von Wärme und Entfernen des erweichten oder teilweise verflüssigten Materials der Schichten. Die Erwärmung des belichteten Reliefvorläufers kann mit allen dem Fachmann bekannten Methoden durchgeführt werden, wie beispielsweise durch Bestrahlung mit IR-Licht, Beaufschlagung mit heißen Gasen (z.B. Luft), mittels heißer Rollen oder beliebigen Kombinationen davon. Zur Entfernung der (zäh)flüssigen Bereiche können alle dem Fachmann geläufigen Verfahren und Methoden eingesetzt werden, wie beispielsweise Abblasen, Absaugen, Abtupfen, Abstrahlen (mit Partikeln und/oder Tröpfchen), Abstreifen, Abwischen, Übertragung auf ein Entwicklungsmedium und beliebige Kombinationen davon. Vorzugsweise wird das flüssige Material von einem Entwicklungsmedium aufgenommen (absorbiert und/oder adsorbiert), das kontinuierlich mit der erhitzten Oberfläche des Reliefvorläufers in Kontakt gebracht wird. Der Vorgang wird so oft wiederholt, bis die gewünschte Reliefhöhe erreicht ist. Als Entwicklungsmedien können Papiere, Gewebe, Vliese und Filme benutzt werden, die das verflüssigte Material aufnehmen können und aus Natur- und/oder Kunststofffasern bestehen können. Vorzugsweise werden Vliese oder nicht gewebte Faserbahnen aus Polymeren wie Cellulosen, Baumwolle, Polyestern, Polyamiden, Polyurethanen und beliebige Kombinationen davon verwendet, die bei den Temperaturen, die bei der Entwicklung angewendet werden, stabil sind.

Optional können anschließend an die vorhergehenden Schritte weitere Behandlungsschritte durchgeführt werden. Dazu gehören beispielsweise eine thermische Behandlung, eine Trocknung, eine Behandlung mit elektromagnetischen Strahlen, mit Plasma, mit Gasen oder mit Flüssigkeiten, Anbringung von Identifikationsmerkmalen, Zuschneiden, Beschichtung und beliebige Kombinationen davon. Eine thermische Behandlung kann beispielswiese zum Start und/oder zur Vervollständigung von Reaktionen, zur Erhöhung der mechanischen und/oder thermischen Beständigkeit der Reliefstruktur und zur Entfernung von flüchtigen Bestandteilen genutzt werden. Zur thermischen Behandlung können die bekannten Methoden verwendet werden, wie beispielsweise Erwärmung durch erwärmte Gase oder Flüssigkeiten, IR-Strahlung und beliebige Kombinationen davon. Dabei können Öfen, Gebläse, Lampen und beliebige Kombinationen davon und zum Einsatz kommen. Mit der Behandlung mit Gasen, Plasma und/oder Flüssigkeiten können neben der Entklebung auch Oberflächenmodifikationen bewerkstelligt werden, insbesondere, wenn zusätzlich noch reaktive Substanzen zum Einsatz kommen.

Eine Behandlung mit elektromagnetischer Strahlung kann beispielsweise dazu verwendet werden, um die Oberflächen der Reliefstruktur klebfrei zu machen, die Polymerisations- und/oder Vernetzungsreaktionen auszulösen und/oder zu vervollständigen. Die Wellenlänge der eingestrahlten elektromagnetischen Wellen liegt dabei im Bereich von 200 nm bis 2000 nm, wie oben bereits beschrieben.

Der Code kann neben Angaben zum Typ (Artikelnummer, eine Batchnummer, eine Identifikationsnummer, Angaben zur Dicke der Platte oder einer Schicht, Angaben zur Länge und Breite, Typ) Daten zu den Bedingungen weiterer Prozessschritte umfassen. Beispiele für weitere Prozessschritte sind eine thermische Nachbehandlung zur Trocknung, eine Nachbelichtung zur vollständigen Vernetzung und/oder Entklebung der Oberfläche, Nachbehandlung mit Flüssigkeiten oder Kombinationen davon. Bei einer thermischen Nachbehandlung können die Daten beispielsweise Angaben zur Temperatur, dem Temperaturverlauf und der Dauer umfassen. Im Falle einer Nachbelichtung können die Daten beispielsweise Angaben zum Lampentyp, zur Wellenlänge, zur Temperatur und zur Dauer umfassen.

In einer weiteren Ausführungsform des erfindungsgemäßen Verfahrens ist die reliefbildende Schicht eine fotopolymerisierbare Schicht, auf die eine bebilderbare Maskenschicht aufgebracht wird, wobei Schritt c) die folgenden Schritte umfasst:
ca) Bebilderung der bebilderbaren Maskenschicht, wobei der zweidimensionale Code in die Maskenschicht eingeschrieben wird,
cb) Belichtung der fotopolymerisierbaren Reliefschicht mit elektromagnetischer Strahlung durch die gebildete Maske hindurch;
cc) Entfernung der Reste der bebilderbaren Maske und der nicht belichteten, nicht fotopolymerisierten Teile der fotopolymerisierbaren Reliefschicht.

In dieser Ausführungsform wird die reliefbildende Schicht in Schritt ca) über ein indirektes Verfahren bebildert und dazu eine Maskenschicht bebildert, wobei die bildhafte Information in Form von transparenten und nicht transparenten Bereichen in die Maskenschicht eingebracht wird. Der Reliefvorläufer wird anschließend durch die Maske hindurch belichtet, wobei Strahlung durch die transparenten Bereiche in die reliefbildende Schicht gelangt und eine chemische Reaktion in Gang bringt.

Die Maskenschicht kann dabei eine separate Schicht sein, die nach dem Entfernen einer eventuell vorhandenen Schutzschicht auf den Reliefvorläufer aufgebracht wird oder eine integrale Schicht des Vorläufers, die mit der Reliefschicht oder eine der optionalen Schichten über der Reliefschicht in Kontakt und von einer gegebenenfalls vorhandenen Schutzschicht bedeckt ist.

Die Maskenschicht kann auch ein handelsübliches Negativ sein, das beispielsweise mittels photographischer Verfahren basierend auf Silberhalogenidchemie erzeugt werden kann. Die Maskenschicht kann ein Schichtverbundmaterial sein bei welchem durch bildweise Belichtung in einer ansonsten intransparenten Schicht transparente Bereiche erzeugt werden, wie beispielsweise in EP 3 139 210 A1, EP 1 735 664 B1, EP 2987 030, A1 EP 2 313 270 B1 beschrieben. Dies kann durch Ablation einer intransparenten Schicht auf einer transparenten Trägerschicht erfolgen, wie z.B. in US 6,916,596, EP 816 920 B1 beschrieben, oder durch selektives Auftragen einer intransparenten Schicht auf eine transparente Trägerschicht, wie in EP 992 846 B1 beschrieben, oder direkt auf die reliefbildende Schicht, wie beispielsweis durch Bedrucken mit einer intransparenten Tinte mittels Ink-Jet, wie z.B. in EP 1 195 645 A1 beschrieben.

Vorzugsweise ist die Maskenschicht eine integrale Schicht des Reliefvorläufers und befindet sich in direktem Kontakt mit der reliefbildenden Schicht oder einer auf der reliefbildenden Schicht angeordneten funktionalen Schicht, bei der es sich vorzugsweise um eine Barriereschicht handelt. Weiterhin ist die integrale Maskenschicht durch Ablation bebilderbar und zudem mit Lösungsmitteln oder durch Erwärmen und Adsorbieren/Absorbieren entfernbar. Diese Schicht wird durch selektive Bestrahlung mittels hochenergetischer elektromagnetischer Strahlung erwärmt und verflüchtigt, wodurch eine bildhaft strukturierte Maske erzeugt wird, die zur Übertragung der Struktur auf den Reliefvorläufer genutzt wird. Dazu muss sie im UV-Bereich undurchlässig sein und im VIS-IR-Bereich Strahlung absorbieren, die zur Erwärmung der Schicht und ihrer Ablation führt. Nach der Ablation stellt auch die Maskenschicht ein Relief dar, wenn auch mit geringeren Reliefhöhen im Bereich von 0,1 bis 5 um.

Die optische Dichte der Maskenschicht im UV-Bereich von 330 bis 420 nm und/oder im VIS-IR-Bereich von 340 bis 660 nm liegt dabei im Bereich von 1 bis 5, bevorzugt im Bereich von 1,5 bis 4, besonders bevorzug im Bereich von 2 bis 4.

Die Schichtdicke der laserablatierbaren Maskenschicht beträgt in der Regel 0,1 bis 5 µm. Bevorzugt beträgt die Schichtdicke 0,3 bis 4 µm, besonders bevorzugt 1 µm bis 3 µm. Die Laserempfindlichkeit der Maskenschicht (gemessen als die Energie, die notwendig ist, um 1 cm2 Schicht zu ablatieren) sollte zwischen 0,1 und 10 mJ/cm2, bevorzugt zwischen 0,3 und 5 mJ/cm2, besonders bevorzugt zwischen 0,5 und 5 mJ/cm2 liegen.

Zur Ablation der Maskenschicht können die gleichen Lichtquellen und Wellenlängen verwendet werden, wie oben im Zusammenhang mit der Lasergravur beschrieben.

In Schritt cb) wird die reliefbildende Schicht durch die aufgebrachte und bebilderte Maske belichtet, wobei zur Belichtung im allgemeinen Quellen eingesetzt werden, die eine flächige Bestrahlung ermöglichen. Dies kann durch Verwendung von optischen Vorrichtungen beispielsweise zur Strahlaufweitung geschehen, durch flächige Anordnung von mehreren punkt- oder linienförmigen Quellen (beispielsweise Lichtleiter, Strahler), wie beispielsweise nebeneinander angeordneten Leuchtstoffröhren, durch Bewegung einer linienförmigen Quelle oder einer länglichen Anordnung von LEDs (Array) relativ zum Reliefvorläufer, beispielsweise durch gleichförmige Bewegung einer LED-Leiste oder Kombinationen davon. Vorzugsweise werden nebeneinander angeordnete Leuchtstoffröhren oder eine Relativbewegung zwischen einer oder mehreren LED-Leisten und dem Reliefvorläufer eingesetzt.

Die Bestrahlung kann dabei kontinuierlich, gepulst oder in mehreren kurzen Perioden mit kontinuierlicher Strahlung erfolgen. Die Intensität der Strahlung kann dabei über einen weiten Bereich variiert werden, wobei sicher zu stellen ist, dass eine Dosis verwendet wird, die ausreicht, um die reliefbildende Schicht für den späteren Entwicklungsvorgang ausreichend zu vernetzen. Die strahlungsinduzierte Reaktion muss ggf. nach weiteren thermischen Behandlungen soweit fortgeschritten sein, dass die belichteten Bereiche mindestens teilweise unlöslich werden und somit im Entwicklungsschritt nicht entfernt werden können. Intensität und Dosis der Strahlung sind abhängig von der Reaktivität der Formulierung und der Dauer und Effizienz der Entwicklung. Die Intensität der Strahlung liegt im Bereich von 1 bis 15 000 mW/cm2, bevorzugt im Bereich von 5 bis 5000 mW/cm2, besonders bevorzugt im Bereich von 10 bis 1000 mW/cm2. Die Dosis der Strahlung liegt im Bereich von 0,3 bis 6000 J/cm2, bevorzugt im Bereich von 3 bis 100 J/cm2, besonders bevorzugt im Bereich von 6 bis 20 J/cm2. Das Einwirken der Strahlung kann auch in einer inerten Atmosphäre, beispielsweise in Edelgasen, CO2 und/oder Stickstoff oder unter einer Flüssigkeit, die das Mehrschichtelement nicht beschädigt, durchgeführt werden.

Die Wellenlänge der elektromagnetischen Strahlung liegt dabei im Bereich von 200 bis 2000 nm, bevorzugt im Bereich von 250 bis 1100 nm, besonders bevorzugt im UV Bereich, ganz besonders bevorzugt im Bereich von 300 bis 450 nm. Neben breitbandiger Einstrahlung der elektromagnetischen Wellen kann es vorteilhaft sein, schmalbandige oder monochromatische Wellenlängenbereiche zu verwenden, wie sie unter Einsatz von entsprechenden Filtern, Lasern oder Light Emitting Diodes (LEDs) erzeugt werden können. In diesen Fällen sind Wellenlängen von 350 nm, 365 nm, 385 nm, 395 nm, 400 nm, 405 nm, 532 nm, 830 nm, 1064 nm (und ca. 5 nm bis 10 nm darüber und/oder darunter), einzeln oder in Kombination, bevorzugt.

In Schritt cc) werden sowohl die bebilderbare Maske und die nicht belichteten, nicht fotopolymerisierten Teile der fotopolymerisierbaren reliefbildende Schicht entfernt, wobei die oben im Zusammenhang mit der direkten Belichtung beschriebenen Entwicklungsverfahren zum Einsatz kommen können. Es kann dabei sein, dass die Maskenschicht und die nicht belichteten Teile der reliefbildenden Schicht mit unterschiedlichen Verfahren entfernt werden, so dass Kombinationen der genannten Verfahren eingesetzt werden. Beispielsweise kann die Maskenschicht mittels wässriger Lösungen und die reliefbildende Schicht mit organischen Lösungen entwickelt werden oder umgekehrt. Es kann auch eine Kombination von thermischer Entwicklung mit einer Entwicklung mittels Flüssigkeit eingesetzt werden. Vorzugsweise wird eine Entwicklungsmethode gewählt, die alle Schichten mit dem gleichen Verfahren entfernt.

In speziellen Ausführungsformen des erfindungsgemäßen Verfahrens ist der mindestens eine zweidimensionale Code ein Strichcode, ein Datenmatrixcode, ein QR-Code oder ein Dot-Code. Weitere geeignete Codes sind beispielsweise MicroQR, DataMatrix (ECC200), GS1 DataMatrix, PDF417, MicroPDF417, GS1 Composite (CC-A/CC-B/CC-C), CODE39, ITF, 2of5(Industrial 2of5), COOP 2of5, NW-7 (Codabar), CODE128, GS1-128, GS1 DataBar, CODE93, JAN/EAN/UPC, Trioptic CODE39, CODE39 Full ASCII oder Pharmacodes. Diese Codes, ihre Erzeugung und der Rücktransfer in Daten sind dem Fachmann hinlänglich bekannt. Darüber hinaus sind auch Kombinationen dieser Codes einsetzbar, um verschiedene Datentypen in verschiedenen Codes zur Verfügung zu stellen, beispielsweise um Daten zum Typ des Reliefvorläufers als Strichcode und die Daten zur Prozesssteuerung als Datamatrixcode bereitzustellen.

In einer weiteren speziellen Ausführungsform des erfindungsgemäßen Verfahrens werden zwei oder mehr unterschiedliche Codes für unterschiedliche Prozessschritte eingesetzt. Dabei kann ein Gerät nur den Code auslesen, der Daten zum entsprechenden Prozessschritt enthält. Dadurch kann die Menge an auszulesenden Daten in den einzelnen Prozessschritten begrenzt werden.

Gegenstand der vorliegenden Erfindung ist auch ein Verfahren zur Herstellung eines Reliefs, insbesondere einer Druckplatte ausgehend von einem Reliefvorläufer, insbesondere einem Druckplattenvorläufer, umfassend mindestens einen Träger, eine reliefbildende Schicht sowie eine Maskenschicht mit den Verfahrensschritten:
(A) Bereitstellung des Reliefvorläufers;
(B) Bereitstellung von Daten, welche den Typ des Reliefvorläufers kennzeichnen und/oder Prozessparameter für seine Verarbeitung enthalten;
(C) Bebilderung der Maskenschicht, wodurch eine Maske gebildet wird;
(D) Belichtung des bebilderten Reliefvorläufers mit elektromagnetischer Strahlung durch die gebildete Maske hindurch;
(E) Entfernen der Reste der bebilderbaren Maskenschicht und von entweder den belichteten oder den nicht belichteten Bereichen der reliefbildenden Schicht;
(F) optional Nachbehandlung des erhaltenen Reliefs;
(G) optional Rückseitenbelichtung des Reliefvorläufers oder des Reliefs mit elektromagnetischer Strahlung, wahlweise zwischen den Schritten (B) und (C), (C) und (D) oder (D) und (E);
dadurch gekennzeichnet, dass die Daten, welche den Typ des Reliefvorläufers kennzeichnen und/oder Prozessparameter für dessen Verarbeitung enthalten, in Schritt (C) in Form eines zweidimensionalen Codes in die Maskenschicht eingeschrieben werden, und nach Schritt (C) die in dem Code enthaltenen Daten zur Steuerung eines oder mehrerer der Schritte (D), (E), (F) und (G) ausgelesen werden. Schritt (G) kann wahlweise zwischen den Schritten (B) und (C), (C) und (D) oder (D) und (E) erfolgen und sorgt für eine Versockelung des Reliefs auf dem Träger.

In diesem Verfahren werden die im Code abgelegten Daten vor den jeweiligen Einzelschritten ausgelesen und zur Steuerung der Prozessschritte verwendet. Dabei werden die Schritte (A) bis (E) wie oben für die Schritte a), b), ca), cb) und cc) beschrieben durchgeführt. Schritt (F) ist optional und hängt von der Natur des Reliefvorläufers ab. Dazu gehören beispielsweise eine thermische Behandlung, eine Trocknung, eine Behandlung mit elektromagnetischen Strahlen, mit Plasma, mit Gasen oder mit Flüssigkeiten, Anbringung von Identifikationsmerkmalen, Zuschneiden, Beschichtung sowie beliebige Kombinationen dieser Schritte.

Bei Reliefvorläufern, die mit Flüssigkeiten entwickelt werden, wird vorzugsweise eine thermische Nachbehandlung stattfinden, um Reste der Flüssigkeiten zu entfernen. Eine thermische Behandlung kann beispielswiese zum Start und/oder zur Vervollständigung von Reaktionen, zur Erhöhung der mechanischen und/oder thermischen Beständigkeit der Reliefstruktur und zur Entfernung von flüchtigen Bestandteilen genutzt werden. Zur thermischen Behandlung können die bekannten Methoden verwendet werden, wie beispielsweise Erwärmung durch erwärmte Gase oder Flüssigkeiten, IR-Strahlung und beliebige Kombinationen davon. Dabei können Öfen, Gebläse, Lampen und beliebige Kombinationen davon und zum Einsatz kommen. Die Temperaturen liegen dabei im Bereich von 30 bis 300°C, bevorzugt im Bereich von 50 bis 200°C, besonders bevorzugt im Bereich von 60 bis 150°C.

Durch die Behandlung mit Gasen, Plasma und/oder Flüssigkeiten können neben der Entklebung auch Oberflächenmodifikationen bewirkt werden, insbesondere, wenn zusätzlich noch reaktive Substanzen zum Einsatz kommen. Eine Behandlung mit elektromagnetischer Strahlung kann beispielsweise dazu verwendet werden, um die Oberfläche der Reliefstruktur klebfrei zu machen und die Polymerisations- und/oder Vernetzungsreaktionen zu vervollständigen. Die Wellenlänge der eingestrahlten elektromagnetischen Wellen liegt dabei im Bereich von 200 nm bis 2000 nm unter Verwendung der oben beschriebenen Strahlungsquellen.

Der optionalen Schritt (G) erfordert Trägermaterialien, die für elektromagnetische Strahlung mindestens teilweise transparent sind. Vorzugsweise erfolgt diese Rückseitenbelichtung durch transparente dimensionsstabile Materialien wie beispielsweise Polymerfilme und insbesondere Polyesterfilme als Trägermaterial. Diese Belichtung kann für eine verbesserte Haftung der Reliefschicht auf dem Träger sorgen und im Zusammenspeil mit der Vorderseitenbelichtung zur Einstellung der Reliefhöhe genutzt werden. Dabei wird ein sogenannter Floor oder Sockel gebildet auf dem die Relieferhöhungen fest verankert sind. Zur Durchführung können alle oben beschriebenen Strahlungsquellen, Wellenlängen und Verfahren eingesetzt werden. Die Rückseitenbelichtung kann ohne oder mit einer weiteren Maskenschicht durchgeführt werden, wobei die Anordnung und Struktur dieser Maskenschicht meist so gestaltet ist, dass sie in den Bereichen transparent ist, in denen Relieferhöhungen gebildet werden.

In einzelnen Ausführungsformen des erfindungsgemäßen Verfahrens steuern die in dem Code enthaltenen Daten einen oder mehrere der Schritte (D), (E), (F) und (G) im Hinblick auf einen oder mehrere der nachfolgenden Prozessparameter:
(i) Intensität und/oder Dauer der Belichtung in Schritt (D);
(ii) Wellenlänge oder Wellenlängenbereich in Schritt (D);
(iii) Entwicklungstemperatur und/oder Entwicklungsdauer in Schritt (E);
(iv) Temperatur und/oder Behandlungszeit in Schritt (F);
(v) Intensität und/oder Belichtungszeit in Schritt (G);
(vi) Wellenlänge der elektromagnetischen Strahlung in Schritt (G);
(vii) Transportgeschwindigkeit des Reliefvorläufers bzw. des Reliefs beim Durchlaufen eines oder mehrerer der Verfahrensschritte (D) bis (G).

Die im Code enthaltenen Daten steuern die einzelnen Prozessschritte, die zur Herstellung des Reliefs durchgeführt werden, und enthalten insbesondere die für die einzelnen Prozessschritte wichtigen Parameter. In Schritt (D) sind das vor allem die Intensität und/oder die Dauer der Belichtung mit elektromagnetischer Strahlung bzw. die Strahlungsdosis, die sich aus der Intensität und Dauer ergibt. Die Intensitäten und Dosen bewegen sich dabei in den oben beschriebenen Bereichen. Für den Fall, dass unterschiedliche Strahlungsquellen oder Strahlungsquellen mit steuerbarem Wellenlängenbereich eingesetzt werden, ist auch dies in den Daten enthalten. Für den Fall dass die Wellenlängenbereiche bestimmten Strahlungsquellen zugeordnet werden können, ist die Angabe der Strahlungsquelle möglich. Bei beweglichen Strahlungsquellen können zudem die Bewegungsgeschwindigkeit, die Bewegungsrichtung, die Wiederholfrequenz bei Mehrfachbelichtung, der Abstand von der Vorläuferoberfläche, der Einstrahlwinkel der Strahlung, die Temperatur und ihre Regelung oder Kombinationen dieser Parameter in den Daten enthalten sein.

Für Schritt (E) sind insbesondere die Entwicklungstemperatur und die Dauer wichtig und in den Daten enthalten. Darüber hinaus können weitere Daten enthalten sein, wie beispielswiese die Art der zu verwendenden Flüssigkeit, Durchflussraten, die Drehzahl von Bürsten, Anpressdruck der Bürsten und Abstand der Bürsten, die ggf. zum Einsatz kommen, Sensordaten zur Kontrolle der Qualität der Flüssigkeiten (wie beispielsweise Viskosität, Festkörpergehalt, Zusammensetzung, Temperatur, Druck, Dichte, Wärmeleitfähigkeit, Oberflächenspannung, Kompressibilität etc.) und Kombinationen davon. Im Falle einer thermischen Entwicklung können die Daten neben der Temperatur verschiedener Gerätekomponenten oder Gerätesegmente beispielsweise die Transportgeschwindigkeit des Reliefvorläufers, die Geschwindigkeit des Entwicklungsmediums, die Zahl der Zyklen, der Anpressdruck der Walzen, die Art und Beschaffenheit des Entwicklungsmediums, Anpressdruckverteilung und Kombinationen davon enthalten.

Für die Nachbehandlung in Schritt (F) kann der Code sehr unterschiedliche Daten enthalten, die von der Art der Nachbehandlung abhängen. Im Allgemeinen wird die Dauer der Nachbehandlung in den Daten enthalten sein. Bei einer thermischen Nachbehandlung kann deren Temperatur in den Daten enthalten sein. Bei einer Trocknung können neben der Temperatur der Trocknung, deren Verlauf und Verteilung, und der Dauer der Trocknung auch Gasdurchsatz, Gasdruck, Volumenstrom, Gasgeschwindigkeit, Massenstrom oder Kombinationen davon in den Daten enthalten sein. Bei einer Nachbelichtung können Wellenlängenbereich, Intensität und/oder Dauer der Belichtung mit elektromagnetischer Strahlung bzw. die Strahlungsdosis in den Daten enthalten sein. Bei einer Behandlung mit Flüssigkeiten, Gasen oder Plasma können die das verwendete Gas, die Flüssigkeit, die Zusammensetzung, Temperatur, Durchflussraten, Drücke, Volumenstrom, Massenstrom, Wärmeleitfähigkeit, Kompressibilität oder Kombinationen davon angeben. Im Falle des Zuschneidens des Reliefs können beispielsweise Größen wie Länge, Breite, Durchmesser, Positionen, Konturen und Schnittrichtung in den Daten enthalten sein.

In Schritt (G) sind das vor allem die Intensität und/oder die Dauer der Belichtung mit elektromagnetischer Strahlung bzw. die Strahlungsdosis, die sich aus der Intensität und Dauer ergibt. Die Intensitäten und Dosen bewegen sich dabei in den oben beschriebenen Bereichen. Für den Fall, dass unterschiedliche Strahlungsquellen oder Strahlungsquellen mit steuerbarem Wellenlängenbereich eingesetzt werden, ist auch dies in den Daten enthalten. Für den Fall dass die Wellenlängenbereiche bestimmten Strahlungsquellen zugeordnet werden können ist die Angabe der Strahlungsquelle möglich. Bei beweglichen Strahlungsquellen kann zudem die Bewegungsgeschwindigkeit, die Bewegungsrichtung, die Wiederholfrequenz, der Abstand von der Vorläuferoberfläche, der Einstrahlwinkel der Strahlung, die Temperatur und ihre Regelung oder Kombinationen davon in den Daten enthalten sein.

Bei einigen Prozessen wird der Vorläufer oder das Relief mit einer bestimmten Geschwindigkeit bewegt und diese Transportgeschwindigkeit kann in den Daten für einzelne Prozessschritte enthalten sein. Diese Transportgeschwindigkeit kann in allen Prozessen gleich oder unterschiedlich sein. In Vorrichtungen, in welchen alle Prozessschritte durchgeführt werden und kontinuierlich ablaufen, ist eine einheitliche Transportgeschwindigkeit vorteilhaft. Geschwindigkeitsbestimmende, langsame Prozesse können jedoch auch mit einer abweichenden Geschwindigkeit durchgeführt werden, insbesondre am Anfang oder am Ende einer Prozesskette. Wenn die Prozessschritte in getrennten Vorrichtungen abgearbeitet werden, sind die Geschwindigkeiten vorzugsweise unterschiedlich. Die Transportgeschwindigkeiten bewegt sich dabei im Bereich von 10 bis 2000 mm/min, bevorzugt im Bereich von 20 bis 1500 mm/min, besonders bevorzugt im Bereich von 50 bis 1000 mm/min und ganz besonders bevorzugt im Bereich von 100 bis 1000 mm/min.

Gegenstand der Erfindung ist weiterhin ein Verfahren zur Herstellung eines Reliefs, insbesondere einer Druckplatte, ausgehend von einem Reliefvorläufer, insbesondere einem Reliefvorläufer, umfassend mindestens einen Träger und eine fotoempfindliche, reliefbildende Schicht mit den Verfahrensschritten:
(A) Bereitstellung des Reliefvorläufers;
(B) Bereitstellung von Daten, welche den Typ des Reliefvorläufers kennzeichnen und/oder Prozessparameter für seine Verarbeitung enthalten;
(C) direkte, bildmäßige Belichtung des Reliefvorläufers;
(D) Entfernen der belichteten oder nicht belichteten Bereiche der reliefbildenden Schicht;
(E) optional Nachbehandlung der erhaltenen Druckplatte;
(F) optional Rückseitenbelichtung des Reliefvorläufers oder des Reliefs mit elektromagnetischer Strahlung, wahlweise zwischen den Schritten (B) und (C) oder (C) und (D);
dadurch gekennzeichnet, dass die Daten, welche den Typ des Reliefvorläufers kennzeichnen und/oder Prozessparameter für dessen Verarbeitung enthalten, in Schritt (C) in Form eines zweidimensionalen Codes durch Direktbelichtung in die reliefbildende Schicht eingeschrieben werden, und nach Schritt (C) die in dem Code enthaltenen Daten zur Steuerung eines oder mehrerer der Schritte (D), (E) und (F) ausgelesen werden. Schritt (G) kann wahlweise zwischen den Schritten (B) und (C) oder (C) und (D) erfolgen und sorgt für eine Versockelung des Reliefs auf dem Träger. Dieses Verfahren unterscheidet sich von dem vorstehend beschriebenen Verfahren lediglich dadurch, dass keine Maske erzeugt wird, sondern die bildmäßige Belichtung direkt stattfindet. Deshalb gelten für alle weiteren Schritte und die diese Schritte steuernden Daten die vorstehenden Angaben und Beschreibungen.

In speziellen Ausführungsform ist dieses Verfahren steuern die in dem Code enthaltenen Daten einen oder mehrere der Schritte (D), (E) und (F) im Hinblick auf einen oder mehrere der nachfolgenden Prozessparameter:
(i) Entwicklungstemperatur und/oder Entwicklungsdauer in Schritt (D);
(ii) Temperatur und/oder Entwicklungszeit in Schritt (E);
(iii) Intensität und/oder Belichtungszeit in Schritt (F);
(iv) Wellenlänge der elektromagnetischen Strahlung in Schritt (F)
(v) Transportgeschwindigkeit des Reliefvorläufers bzw. des Reliefs beim Durchlaufen eines oder mehrerer der Verfahrensschritte (D) bis (F).

Gegenstand der Erfindung ist weiterhin ein Verfahren zur Herstellung von Reliefs ausgehend von einem Reliefvorläufer umfassend mindestens einen Träger und eine reliefbildende, gravierbare Schicht mit den Verfahrensschritten:
(A) Bereitstellung des Reliefvorläufers;
(B) Bereitstellung von Daten, welche den Typ des Reliefvorläufers kennzeichnen und/oder Prozessparameter für seine Verarbeitung enthalten;
(C) optional vollflächige Belichtung oder thermische Behandlung des Reliefvorläufers;
(D) Einschreiben eines dreidimensionalen Reliefs in die reliefbildende Schicht durch materialabtragende Methoden;
(E) optional Entfernung von Rückständen von der Reliefoberfläche;
(F) optional Nachbehandlung des erhaltenen Reliefs ;
(G) optional Nachbelichtung des erhaltenen Reliefs mit elektromagnetischer Strahlung;
dadurch gekennzeichnet, dass die Daten, welche den Typ des Reliefvorläufers kennzeichnen und/oder Prozessparameter für dessen Verarbeitung enthalten, in Schritt (D) in Form eines zweidimensionalen Codes durch Lasergravur in die reliefbildende Schicht eingeschrieben werden, und nach Schritt (D) die in dem Code enthaltenen Daten zur Steuerung eines oder mehrerer der Schritte (E), (F) und (G) ausgelesen werden. Dieses Verfahren unterscheidet sich von den vorangehenden Verfahren dadurch, dass die Relieferzeugung mittels einer materialabtragenden Methode erfolgt und eine Belichtung durch einen Maske und ein Entfernen von belichteten oder unbelichteten Bereichen entfallen. Weitere Schritte können wie vorstehend beschrieben durchgeführt und die diese Schritte steuernden Daten wie vorstehend beschrieben beschaffen sein.

In Schritt (D) können alle Methoden eingesetzt werden, die Material abtragen, beispielsweise mechanische Gravur, Ablation oder Gravur unter Zuhilfenahme von energiereicher Strahlung. Bevorzugt wird die sogenannte Lasergravur benutzt, bei der ein energiereicher Laserstahl über den Vorläufer geführt wird, um die bildmäßige Struktur und den Code zu erzeugen. Dabei wird das zu entfernende Material stark erhitzt, zersetzt und entfernt. Als elektromagnetische Strahlung zur Gravur wir in der Regel Strahlung mit einer Wellenlänge im Bereich von 300 bis 20 000 nm, bevorzugt im Bereich von 500 bis 20 000 nm, besonders bevorzugt im Bereich von 800 bis 15 000 nm, ganz besonders bevorzugt im Bereich von 800 bis 11 000 nm verwendet. Vorzugsweise kommt bei der Lasergravur ein CO2-Laser zum Einsatz. Zur selektiven Entfernung der Reliefschicht werden dabei ein oder mehrere Laserstrahlen so gesteuert, dass das gewünschte Bild und der Code erzeugt werden. Die dazu eingesetzten Energien des Laserstrahls liegen im Bereich von 10 bis 1000 Watt, bevorzugt im Bereich von 20 bis 1500 Watt, besonders bevorzugt im Bereich von 50 bis 1000 Watt.

Die Entfernung von Rückständen in Schritt (E) kann durch mechanisches Entfernen, Abspülen mit Flüssigkeit, Absaugen, Abblasen, Abbürsten oder Kombinationen davon erfolgen. Schritt (E) kann auch während Schritt (D) stattfinden, insbesondere, wenn die Rückstände abgesaugt und/oder abgeblasen werden. Bei der Verwendung von Flüssigkeiten ist darauf zu achten, dass diese die Reliefstruktur nicht verändern, insbesondere durch Anlösen oder Quellen. Ein Absaugen hat den Vorteil, dass Rückstände aus der Gasphase entfernt werden können, beispielsweise durch Filter und/oder Abscheider, und somit nicht unkontrolliert in die Umgebung gelangen. Zum Abblasen können Gase verwendet werden, die die Reliefstruktur nicht schädigen und/oder aus Sicherheitsaspekten zulässig sind. Bevorzugt werden Luft und Inertgase wie beispielsweise Stickstoff, Kohlendioxid, Argon oder Kombinationen davon eingesetzt.

Bei Schritt (F) kann es sich um thermische Nachbehandlungen oder Behandlungen mit Plasma, mit Gasen oder mit Flüssigkeiten, Anbringung von Identifikationsmerkmalen, Zuschneiden, Beschichtung und beliebige Kombinationen davon handeln.

In speziellen Ausführungsformen dieses Verfahrens steuern die in dem Code enthaltenen Daten einen oder mehrere der Schritte (E), (F) und (G) im Hinblick auf einen oder mehrere der nachfolgenden Prozessparameter:
(i) Dauer und/oder Temperatur in Schritt (E);
(ii) Über- oder Unterdruck in Schritt (E);
(iii) Temperatur und/oder Dauer in Schritt (F);
(iv) Intensität und/oder Belichtungszeit in Schritt (G);
(v) Wellenlänge der elektromagnetischen Strahlung in Schritt (G);
(vi) Transportgeschwindigkeit des Reliefs beim Durchlaufen eines oder mehrerer der Verfahrensschritte (E) bis (G).

Das Auslesen der Daten in allen vorstehend beschriebenen Ausführungsformen des erfindungsgemäßen Verfahrens kann auf vielfältige Weise erfolgen. Beispielsweise kann es optisch oder mechanisch durch Abtasten erfolgen. Vorzugsweise wird das Auslesen berührungslos bewerkstelligt. Das Auslesen kann dabei automatisch erfolgen, indem das betreffende Gerät oder der betreffende Vorrichtungsteil den Code auf dem Reliefvorläufer erfasst. Es kann aber auch manuell durch einen Operator erfolgen, der den Code mittels eines entsprechenden Auslesegerätes erfasst. In bevorzugten Ausführungsformen des erfindungsgemäßen Verfahrens werden die in dem Code enthaltenen Daten berührungslos erfasst.

Als berührungsloses Verfahren kommen insbesondere optische Verfahren zum Einsatz, wie beispielsweise Auslesen mit einer Kamera und Analyse der Bilder, mit einem Scanner oder Kombinationen davon. Vorzugsweise werden Linien- oder Punkt, bzw. Flächenscanner eingesetzt.

In einer weiteren Ausführungsform des erfindungsgemäßen Verfahrens kennzeichnen die in dem Code enthaltenen Daten den Typ des Reliefvorläufers, wobei die zugehörigen Prozessparameter aus einer Datenbank ausgelesen werden. Daten zum Typ des Reliefvorläufers umfassen beispielsweise eine Artikelnummer, eine Batchnummer, eine Identifikationsnummer, Angaben zur Dicke der Platte oder einer Schicht, Angaben zur Länge und Breite, Typ oder beliebige Kombinationen davon. Anhand dieser Daten kann ein Gerät die zu diesem Vorläufer gehörigen Prozessparameter aus einer Datenbank auslesen und diese zur individuellen Steuerung des Prozesses heranziehen. Die Datenbank kann dabei im Gerät hinterlegt sein und bei Änderungen an den Daten oder in regelmäßigen Abständen auf den neuesten Stand gebracht werden. Die Daten können auch in einer zentralen oder mehreren Datenbanken gespeichert sein und die Geräte können über eine entsprechende elektronische Verbindung darauf zugreifen.

Die Übertragung der Daten von den Auslesegeräten zu den Prozessgeräten kann mittels üblicher Verfahren erfolgen: Wenn die Auslesegeräte in den Prozessgeräten integriert sind, ist die Übertragung per Kabel bevorzugt. Wenn die Auslesegeräte nicht integriert sind, kann die Übertragung per Kabel und eine entsprechende Steckverbindung, via drahtloser Kommunikation wie beispielsweise mittels Funksignalen (Richtfunk, WPAN) oder Lichtsignalen (Infrarotsignalen), via elektronischer Netzwerke, mittels induktiver Effekte (Near Field Communication NFC, RFID) oder Kombinationen davon erfolgen. Funkverbindungen sind auch beispielsweise unter den Begriffen "bluetooth" oder "WLAN" (Wireless Local Area Network) bekannt. Ebenso ist die Übertragung über kabelgebundene Verbindungen wie LAN oder anhand kabelgebundener Protokolle möglich. Die Daten können dabei in allen üblichen Formaten gespeichert und übertragen werden. Vorzugsweise geschient dies mittels sogenannter CSV Files (comma separated values), SDF (simple data format), Textdateien, PTC Dateien, ASCCI Files und/oder nach JSON (Java Script Object Notation). Zur Übertragung können folgende Kommunikationsprotokolle eingesetzt werden, z.B. EtherNet/IP, PROFINET, SPS Link, TCP/IP, FTP, MC-Protokoll, Omron PLC link, KV STUDIO oder Kombinationen davon. Zur Übertragung können folgende Schnittstellen zum Einsatz kommen: USB, RS-232C, drahtlose sowie drahtgebundene Übertragung, Ethernet, WLAN, RFID, GSM/UMTS/LTE, ProfiBus, Modbus, FoundationFieldbus, serielle Schnittstellen oder Kombinationen davon.

Gegenstand der Erfindung ist auch die Reliefstruktur mit dem Code, hergestellt nach den vorangehend beschriebenen Verfahren. Die so hergestellten Reliefstrukturen können als Druckplatten, insbesondere als Flexodruckplatten, Buchdruckplatten, Tampondruckplatten und Tiefdruckplatten verwendet werden. Ebenso können die Reliefstrukturen als optische Bauteile Verwendung finden, beispielsweise als Fresnel-Linse.

Wenn auf die erzeugten Reliefstrukturen mindestens eine weitere Schicht aufgebracht wird, die so steif beschaffen ist, dass diese nicht der Form des Reliefs folgt, entstehen Bauteile mit Kanälen und/oder Hohlräumen, die voneinander getrennt oder miteinander verbunden sein können. Dazu kann die weitere Schicht steif oder unflexibel sein, so dass Sie nicht in die Vertiefungen einsinkt, es können jedoch auch flexible Schichten verwendet werden, wenn man durch geeignete Maßnahmen dafür sorgt, dass die weiter Schicht nicht in die Vertiefungen einsinken kann (beispielsweise in dem die Vertiefungen mit Flüssigkeiten und /oder Gasen aufgefüllt werden und anschließend entfernt werden). Diese Kanäle und/oder Hohlräume können optional mit anderen Materialien und/oder Flüssigkeiten versehen werden. Derartige Bauteile können als mikrofluidisches Bauteil (z.B. zur Mikroanalyse und/oder zum high throughput screening), als Mikroreaktor, optisches Bauteil, etwa als phoretische Zelle (wie beispielsweise in WO 2004/015491 dargestellt), als lichtkontrollierendes Element zur Farbdarstellung (wie beispielsweise in WO2003/062900 beschrieben) oder als photonische Kristalle verwendet werden. Die weitere Schicht kann beispielsweise im Rahmen der Nachbehandlung gemäß Schritt viii) aufgebracht werden. Die oben genannte Bauteile und Komponenten können sowohl steif und/oder flexibel ausgelegt sein. Flexible Ausführungsformen sind besonders dann bevorzugt, wenn sie am und/oder im Körper getragen und/oder in Geweben und/oder in Kleidungsstücken eingesetzt werden sollen.

Gegenstand der Erfindung ist somit auch die Verwendung des erfindungsgemäß hergestellten Reliefs als Tampondruckplatte, Flexodruckplatte, Buchdruckplatte, Tiefdruckplatte, mikrofluidisches Bauteil, Mikroreaktor, phoretische Zelle, photonischer Kristall und optisches Bauteil.

Weitere Ausführungsformen werden unten erwähnt.

### Klauseln

1. Verfahren zur Kennzeichnung eines Reliefvorläufers oder eines Reliefs umfassend einen Träger und eine reliefbildende Schicht mit den Schritten:
   a) Bereitstellung eines Reliefvorläufers umfassend einen Träger und eine reliefbildende Schicht;
   b) Bereitstellung von Daten, welche den Typ des Reliefvorläufers oder Reliefs kennzeichnen und prozessrelevante Daten für dessen Verarbeitung enthalten, in Form mindestens eines zweidimensionalen Codes;
   c) Einbringen des mindestens einen zweidimensionalen Codes als Relief in die reliefbildende Schicht.
2. Verfahren nach Klausel 1, dadurch gekennzeichnet, dass die reliefbildende Schicht eine gravierbare Schicht ist, und in Schritt c) der zweidimensionale Code als Relief durch eine materialabtragende Methode in die reliefbildende Schicht eingebracht wird.
3. Verfahren nach Klausel 1, dadurch gekennzeichnet, dass die reliefbildende Schicht eine fotoempfindliche Schicht ist, und in Schritt c) der zweidimensionale Code durch direkte bildweise Belichtung und nachfolgende Entfernung von entweder den belichteten oder den unbelichteten Bereichen der reliefbildenden Schicht in die reliefbildende Schicht eingebracht wird.
4. Verfahren nach Klausel 1, dadurch gekennzeichnet, dass die reliefbildende Schicht eine fotopolymerisierbare Schicht ist, auf die eine bebilderbare Maskenschicht aufgebracht wird, und Schritt c) die folgenden Schritte umfasst:
   ca) Bebilderung der bebilderbaren Maskenschicht, wobei der zweidimensionale Code in die Maskenschicht eingeschrieben wird,
   cb) Belichtung der fotopolymerisierbaren reliefbildende Schicht mit elektromagnetischer Strahlung durch die gebildete Maske hindurch;
   cc) Entfernung der Reste der bebilderbaren Maske und der nicht belichteten, nicht fotopolymerisierten Teile der fotopolymerisierbaren reliefbildende Schicht.
5. Verfahren nach einem der Klauseln 1 bis 4, dadurch gekennzeichnet, dass der mindestens eine zweidimensionale Code ein Strichcode, Datenmatrixcode, QR-Code oder Dot-Code ist.
6. Verfahren nach einem der Klauseln 1 bis 5, dadurch gekennzeichnet, dass zwei oder mehr unterschiedliche Codes für unterschiedliche Prozessschritte eingebracht werden.
7. Verfahren zur Herstellung eines Reliefs ausgehend von einem Reliefvorläufer umfassend mindestens einen Träger, eine, reliefbildende Schicht sowie eine Maskenschicht mit den Verfahrensschritten:
   (A) Bereitstellung des Reliefvorläufers;
   (B) Bereitstellung von Daten, welche den Typ des Reliefvorläufers kennzeichnen und/oder Prozessparameter für seine Verarbeitung enthalten;
   (C) Bebilderung der Maskenschicht, wodurch eine Maske gebildet wird;
   (D) Belichtung des bebilderten Reliefvorläufers mit elektromagnetischer Strahlung durch die gebildete Maske hindurch;
   (E) Entfernen der Reste der bebilderbaren Maskenschicht und von belichteten oder nicht belichteten Bereichen der reliefbildenden Schicht;
   (F) optional Nachbehandlung des erhaltenen Reliefs;
   (G) optional Rückseitenbelichtung des Reliefvorläufers oder des Reliefs mit elektromagnetischer Strahlung, wahlweise zwischen den Schritten (B) und (C), (C) und (D) oder (D) und (E);
   dadurch gekennzeichnet, dass die Daten, welche den Typ des Reliefvorläufers kennzeichnen und/oder Prozessparameter für dessen Verarbeitung enthalten, in Schritt (C) in Form eines zweidimensionalen Codes in die Maskenschicht eingeschrieben werden, und nach Schritt (C) die in dem Code enthaltenen Daten zur Steuerung eines oder mehrerer der Schritte (D), (E), (F) und (G) ausgelesen werden.
8. Verfahren nach Klausel 7, dadurch gekennzeichnet, dass die in dem Code enthaltenen Daten einen oder mehrere der Schritte (D), (E), (F) und (G) im Hinblick auf einen oder mehrere der nachfolgenden Prozessparameter steuern:
   (i) Intensität und/oder Dauer der Belichtung in Schritt (D);
   (ii) Wellenlänge in Schritt (D);
   (iii) Entwicklungstemperatur und/oder Entwicklungsdauer in Schritt (E);
   (iv) Temperatur und/oder Behandlungszeit in Schritt (F);
   (v) Intensität und/oder Belichtungszeit in Schritt (G);
   (vi) Wellenlänge der elektromagnetischen Strahlung in Schritt (G);
   (vii) Transportgeschwindigkeit des Reliefvorläufers bzw. des Reliefs beim Durchlaufen eines oder mehrerer der Verfahrensschritte (D) bis (G).
9. Verfahren zur Herstellung eines Reliefs ausgehend von einem Reliefvorläufer umfassend mindestens einen Träger und eine fotoempfindliche, reliefbildende Schicht mit den Verfahrensschritten:
   (A) Bereitstellung des Reliefvorläufers;
   (B) Bereitstellung von Daten, welche den Typ des Reliefvorläufers kennzeichnen und/oder Prozessparameter für seine Verarbeitung enthalten;
   (C) direkte, bildmäßige Belichtung des Reliefvorläufers;
   (D) Entfernen der belichteten oder nicht belichteten Bereiche der reliefbildenden Schicht;
   (E) optional Nachbehandlung des erhaltenen Reliefs;
   (F) optional Rückseitenbelichtung des Reliefvorläufers oder des Reliefs mit elektromagnetischer Strahlung, wahlweise zwischen den Schritten (B) und (C) oder (C) und (D);
   dadurch gekennzeichnet, dass die Daten, welche den Typ des Reliefvorläufers kennzeichnen und/oder Prozessparameter für dessen Verarbeitung festlegen, in Schritt (C) in Form eines zweidimensionalen Codes durch Direktbelichtung in die reliefbildende Schicht eingeschrieben werden, und nach Schritt (C) die in dem Code enthaltenen Daten zur Steuerung eines oder mehrerer der Schritte (D), (E) und (F) ausgelesen werden.
10. Verfahren nach Klausel 9, dadurch gekennzeichnet, dass die in dem Code enthaltenen Daten einen oder mehrere der Schritte (D), (E) und (F) im Hinblick auf einen oder mehrere der nachfolgenden Prozessparameter steuern:
   (i) Entwicklungstemperatur und/oder Entwicklungsdauer in Schritt (D);
   (ii) Temperatur und/oder Entwicklungszeit in Schritt (E);
   (iii) Intensität und/oder Belichtungszeit in Schritt (F);
   (iv) Wellenlänge der elektromagnetischen Strahlung in Schritt (F);
   (v) Transportgeschwindigkeit des Reliefvorläufers bzw. des Reliefs beim Durchlaufen eines oder mehrerer der Verfahrensschritte (D) bis (F).
11. Verfahren zur Herstellung von Reliefs ausgehend von einem Reliefvorläufer umfassend mindestens einen Träger und eine reliefbildende, gravierbare Schicht mit den Verfahrensschritten:
   (A) Bereitstellung des Reliefvorläufers;
   (B) Bereitstellung von Daten, welche den Typ des Reliefvorläufers kennzeichnen und/oder Prozessparameter für seine Verarbeitung enthalten;
   (C) optional vollflächige Belichtung oder thermische Behandlung des Reliefvorläufers;
   (D) Einschreiben eines dreidimensionalen Reliefs in die reliefbildende Schicht durch materialabtragende Methoden;
   (E) optional Entfernung von Rückständen von der Reliefoberfläche;
   (F) optional Nachbehandlung des erhaltenen Reliefs;
   (G) optional Nachbelichtung des erhaltenen Reliefs mit elektromagnetischer Strahlung;
   dadurch gekennzeichnet, dass die Daten, welche den Typ des Reliefvorläufers kennzeichnen und/oder Prozessparameter für dessen Verarbeitung enthalten, in Schritt (D) in Form eines zweidimensionalen Codes durch Lasergravur in die reliefbildende Schicht eingeschrieben werden, und nach Schritt (D) die in dem Code enthaltenen Daten zur Steuerung eines oder mehrerer der Schritte (E), (F) und (G) ausgelesen werden.
12. Verfahren nach Klausel 11, dadurch gekennzeichnet, dass die in dem Code enthaltenen Daten einen oder mehrere der Schritte (E), (F) und (G) im Hinblick auf einen oder mehrere der nachfolgenden Prozessparameter steuern:
   (i) Dauer und/oder Temperatur in Schritt (E);
   (ii) Über- oder Unterdruck in Schritt (E);
   (iii) Temperatur und/oder Dauer in Schritt (F);
   (iv) Intensität und/oder Belichtungszeit in Schritt in Schritt (G);
   (v) Wellenlänge der elektromagnetischen Strahlung in Schritt (G);
   (vi) Transportgeschwindigkeit des Reliefs beim Durchlaufen eines oder mehrerer der Verfahrensschritte (E) bis (G).
13. Verfahren nach den Klauseln 1 bis 12, dadurch gekennzeichnet, dass das Auslesen der in dem Code enthaltenen Daten berührungslos erfolgt.
14. Verfahren nach den Klauseln 1 bis 13, dadurch gekennzeichnet, dass die in dem Code enthaltenen Daten den Typ des Reliefvorläufers kennzeichnen und zugehörige Prozessparameter aus einer Datenbank ausgelesen werden.
15. Reliefstruktur mit Code, herstellbar nach dem Verfahren gemäß einem der Ansprüche 1-14.
16. Verwendung einer Reliefstruktur nach Klausel 15 als Tiefdruckplatte, Tampondruckplatte, Flexodruckplatte, Buchdruckplatte, mikrofluidisches Bauteil, als Mikroreaktor, als phoretische Zelle, als lichtkontrollierendes Element zur Farbdarstellung, als photonischer Kristall oder als flexible Teile von Bekleidungsstücken.

### Beispiele:

Bei den Beispielen fand die Informationsübertragung mittels der Steuersoftware CX Server-lite Version 2.2 von OMRON ELECTRONICS GmbH statt. Dazu wurde der Code mittels eines SR-G100 Scanner (Keyence, Einstellungen) erfasst, in eine CSV- Datei (Excel) überführt und über eine 2.2-Schnittstelle an die SPS-Steuerung der Geräte übertragen.

### Beispiel 1:

nyloprint^{®} WF-H 80-Platten (Flint Group) mit einer PET-Trägerschicht, einer 50 µm dicken Reliefschicht und Schutzschicht wurden nach Entfernen der Schutzschicht mit einem nyloprint^{®} Exposure 96 X 120 ED (Flint Group) vollflächig für 5 min belichtet. Anschließend wurden die Platten mit einem Kronos 7612 (SPGPrints Austria GmbH) ausgerüstet mit einem 750 W CO2 -Laser mit einer Auflösung von 2540 dpi graviert. Dabei wurde im Randbereich ein Code als Relief mit Daten (Durchlaufgeschwindigkeit und Trocknungstemperatur) zur nachfolgenden Reinigung und Trocknung erzeugt. Der Code wurde mit einem SR-G100 Scanner (Keyence) ausgelesen und in einen nyloprint DWT 100 eingelesen. Die Platte wurde mit 300 mm/min mit Wasser gewaschen und bei 60°C getrocknet.

### Beispiel 2:

nyloflex^{®} Sprint 114-Platten (Flint Group) mit einer PET Trägerschicht, einer Reliefschicht und Schutzschicht wurden 30 s mit einem nyloprint^{®} Exposure 96 X 120 ED-Belichter von der Rückseite vollflächig belichtet. Nach Entfernen der Schutzschicht wurden sie mit einem MultiDX! 220 (Lüscher Technologies AG), ausgerüstet mit X!Direct Software und mit UV-Laserdioden, die Licht mit einer Wellenlänge im Bereich von 405 nm erzeugen, mit einer Dosis von 600 mJ/cm2 direkt belichtet. Dabei wurde im Randbereich ein Code als Relief mit Daten zu Durchlaufgeschwindigkeit (170 mm/min), Trocknungstemperatur (60°C) und Nachbelichtung mit UVA erzeugt. Die Platten wurden in einen nyloprint flowline washer DWT 100 bei einer Durchlaufgeschwindigkeit von 170 mm/min und unter Verwendung von Wasser entwickelt und entsprechend den eingelesenen Daten bei 60°C getrocknet und 2 min lang mit UVA-Licht nachbelichtet.

### Beispiel 3:

nyloflex^{®} FAC 284-Platten (Flint Group) mit einer PET-Trägerschicht, einer Reliefschicht und Schutzschicht wurden 100 s lang mit einem nyloflex Exposure FV-Belichter (Flint Group) von der Rückseite vollflächig belichtet. Zur Steuerung des Belichters wurde mittels eines SR-G100 Scanner (Keyence) ein Datamatrixcode eingelesen, der die Belichtungsbedingungen (Zeit) umfasste. Nach Entfernen der Schutzschicht wurden die Platten durch eine Maske LADF 0175 dry film (Folex) mit einem nyloflex Exposure FV (Flint Group) unter Einsatz von LED-Licht mit der Wellenlänge von 365 nm und der Intensität 20 mW/cm² für 15 min belichtet. Die Maske enthielt dabei einen Datamatrixcode mit den zusätzlichen Angaben zu den weiteren Prozessschritten (Hauptbelichtung 20 min, Auswaschgeschwindigkeit 190 mm/min, Trocknungszeit 124 min bei 60°C, Nachbelichtung simultan UVA/UVC 12,5 min). Der Code wurde mit einem SR-G100 Scanner (Keyence) ausgelesen und in einen nyloflex Automated Plate Processor eingelesen, wodurch die Platten entsprechend den eingelesenen Daten entwickelt, getrocknet und nachbelichtet wurden.

### Beispiel 4:

Als Reliefvorläufer wurden mit einer Maskenschicht versehene nyloflex^{®} FAC 284 D-Platten (Flint Group) mit einer PET-Trägerschicht, einer Reliefschicht, einer Maskenschicht und einer Schutzschicht verwendet und die dazugehörigen Prozessdaten in einen Datamatrixcode überführt.

Die Platten wurden für 100 s mit einem nyloflex NExT Exposure FV-Belichter (Flint Group) mittels Leuchtstoffröhren von der Rückseite vollflächig belichtet. Nach dem Entfernen der Schutzschicht wurden auf den Vorläufer durch Laserablation der Datamatrixcode in einem Randbereich erzeugt und die Bebilderung der Maskenschicht vorgenommen. Die Ablation wurde mit einem ThermoFlexX 80 D (Xeikon, Laserleistung 100 W), der Software Multiplate (Version 5.0.0.276) und folgenden Parametern vorgenommen: Wellenlänge 1070 nm, Mode 3. Der Datamatrixcode enthielt Informationen zu Plattentyp, Plattendicke, Belichtungsbedingungen und Entwicklungsbedingungen, Trocknungstemperatur und Trocknungszeit sowie Nachbelichtungsbedingungen. Mit einem SR-G100 Scanner (Keyence) wurde der Code auf der Maskenschicht ausgelesen und in den nachfolgenden Belichter eingelesen.

Die UV-Belichtung erfolgte bei mit einem nyloflex NExT Exposure FV (Flint Group) unter Einsatz von LED-Licht mit der Wellenlänge von 365 nm und entsprechend dem S4 Setting.

Mit einem SR-G100-Scanner (Keyence) wurde der Code auf der Maskenschicht ausgelesen und in den nachfolgenden Entwickler eingelesen. Die Entwicklung erfolgte dann mit Lösungsmittel in einem FIII-Auswascher (Flint Group) bei 35 °C unter Verwendung von nylosolv A (Flint Group) als Entwicklungslösung mit einer Durchlaufgeschwindigkeit von 60 mm/min.

Mit einem SR-G100-Scanner (Keyence) wurde der Code auf der Reliefstruktur ausgelesen und in den nachfolgenden nyloflex Dryer FV-Trockner eingelesen. Die Trocknung erfolgte über 180 Minuten bei 60°C.

Mit einem SR-G100-Scanner (Keyence) wurde der Code auf der Reliefstruktur ausgelesen und in den nachfolgenden Combi FIII Belichter (Flint Group) eingelesen. Es wurde gleichzeitig mit 15 Minuten UVA und UVC nachbelichtet.

### Beispiel 5:

Beispiel 4 wurde wiederholt, jedoch wurden nach der Ablation der Maskenschicht die Daten (Hauptbelichtung 20 mim, Auswaschgeschwindigkeit 190 mm/min, Trocknungszeit 124 min bei 60°C, Nachbelichtung simultan UVA/UVC 12,5 min) in einen nyloflex Automated Plate Processor eingelesen, wodurch die Platten entsprechend den eingelesenen Daten entwickelt, getrocknet und nachbelichtet wurden.

### Beispiel 6:

Beispiel 4 wurde wiederholt, jedoch wurde ein Code verwendet, der neben der Artikelnummer auch die Chargennummer enthielt. Mit diesen Daten suchte das Gerät (nyloflex Automated Plate Processor) aus einer angeschlossenen Datenbank die dazugehörigen Daten und benutzte diese zur Verarbeitung.

## Patentansprüche

1. Verfahren zur Kennzeichnung eines Reliefvorläufers oder eines Reliefs umfassend einen Träger und eine reliefbildende Schicht mit den Schritten:
a) Bereitstellung eines Reliefvorläufers umfassend einen Träger und eine reliefbildende Schicht;
b) Bereitstellung von Daten, welche den Typ des Reliefvorläufers oder Reliefs kennzeichnen und/oder prozessrelevante Daten für dessen Verarbeitung enthalten, in Form mindestens eines Codes;
c) Einbringen des mindestens einen Codes als Relief in die reliefbildende Schicht.

2. Verfahren nach Anspruch 1, wobei die reliefbildende Schicht eine gravierbare Schicht ist, und in Schritt c) der Code als Relief durch eine materialabtragende Methode in die reliefbildende Schicht eingebracht wird.

3. Verfahren nach Anspruch 1, wobei die reliefbildende Schicht eine fotoempfindliche Schicht ist, und in Schritt c) der Code durch direkte bildweise Belichtung und nachfolgende Entfernung von entweder den belichteten oder den unbelichteten Bereichen der reliefbildenden Schicht in die reliefbildende Schicht eingebracht wird.

4. Verfahren nach Anspruch 1, wobei die reliefbildende Schicht eine fotopolymerisierbare Schicht ist, auf die eine bebilderbare Maskenschicht aufgebracht wird, und Schritt c) die folgenden Schritte umfasst:
ca) Bebilderung der bebilderbaren Maskenschicht, wobei der Code in die Maskenschicht eingeschrieben wird,
cb) Belichtung der fotopolymerisierbaren reliefbildende Schicht mit elektromagnetischer Strahlung durch die gebildete Maske hindurch;
cc) Entfernung der Reste der bebilderbaren Maske und der nicht belichteten, nicht fotopolymerisierten Teile der fotopolymerisierbaren reliefbildende Schicht.

5. Verfahren nach einem der Ansprüche 1 bis 4, wobei der mindestens eine Code ein Strichcode, Datenmatrixcode, QR-Code oder Dot-Code ist, und/oder
wobei zwei oder mehr unterschiedliche Codes für unterschiedliche Prozessschritte eingebracht werden, und/oder
wobei Daten in Form von beispielsweise einer Artikelnummer, einer Batchnummer, einer Identifikationsnummer, Angaben zur Dicke der Platte oder einer Schicht, Angaben zur Länge und Breite, Typ oder beliebige Kombinationen davon sind.

6. Verfahren zur Herstellung eines Reliefs ausgehend von einem Reliefvorläufer umfassend mindestens einen Träger, eine, reliefbildende Schicht sowie eine Maskenschicht mit den Verfahrensschritten:
(A) Bereitstellung des Reliefvorläufers;
(B) Bereitstellung von Daten, welche den Typ des Reliefvorläufers kennzeichnen und/oder Prozessparameter für seine Verarbeitung enthalten;
(C) Bebilderung der Maskenschicht, wodurch eine Maske gebildet wird;
(D) Belichtung des bebilderten Reliefvorläufers mit elektromagnetischer Strahlung durch die gebildete Maske hindurch;
(E) Entfernen der Reste der bebilderbaren Maskenschicht und von belichteten oder nicht belichteten Bereichen der reliefbildenden Schicht;
(F) optional Nachbehandlung des erhaltenen Reliefs;
(G) optional Rückseitenbelichtung des Reliefvorläufers oder des Reliefs mit elektromagnetischer Strahlung, wahlweise zwischen den Schritten (B) und (C), (C) und (D) oder (D) und (E);
**dadurch gekennzeichnet, dass** die Daten, welche den Typ des Reliefvorläufers kennzeichnen und/oder Prozessparameter für dessen Verarbeitung enthalten, in Schritt (C) in Form eines Codes in die Maskenschicht eingeschrieben werden, und nach Schritt (C) die in dem Code enthaltenen Daten zur Steuerung eines oder mehrerer der Schritte (D), (E), (F) und (G) ausgelesen werden.

7. Verfahren nach Anspruch 6, wobei die in dem Code enthaltenen Daten einen oder mehrere der Schritte (D), (E), (F) und (G) im Hinblick auf einen oder mehrere der nachfolgenden Prozessparameter steuern:
(i) Intensität und/oder Dauer der Belichtung in Schritt (D);
(ii) Wellenlänge in Schritt (D);
(iii) Entwicklungstemperatur und/oder Entwicklungsdauer in Schritt (E);
(iv) Temperatur und/oder Behandlungszeit in Schritt (F);
(v) Intensität und/oder Belichtungszeit in Schritt (G);
(vi) Wellenlänge der elektromagnetischen Strahlung in Schritt (G);
(vii) Transportgeschwindigkeit des Reliefvorläufers bzw. des Reliefs beim Durchlaufen eines oder mehrerer der Verfahrensschritte (D) bis (G).

8. Verfahren zur Herstellung eines Reliefs ausgehend von einem Reliefvorläufer umfassend mindestens einen Träger und eine fotoempfindliche, reliefbildende Schicht mit den Verfahrensschritten:
(A) Bereitstellung des Reliefvorläufers;
(B) Bereitstellung von Daten, welche den Typ des Reliefvorläufers kennzeichnen und/oder Prozessparameter für seine Verarbeitung enthalten;
(C) direkte, bildmäßige Belichtung des Reliefvorläufers;
(D) Entfernen der belichteten oder nicht belichteten Bereiche der reliefbildenden Schicht;
(E) optional Nachbehandlung des erhaltenen Reliefs;
(F) optional Rückseitenbelichtung des Reliefvorläufers oder des Reliefs mit elektromagnetischer Strahlung, wahlweise zwischen den Schritten (B) und (C) oder (C) und (D);
**dadurch gekennzeichnet, dass** die Daten, welche den Typ des Reliefvorläufers kennzeichnen und/oder Prozessparameter für dessen Verarbeitung festlegen, in Schritt (C) in Form eines Codes durch Direktbelichtung in die reliefbildende Schicht eingeschrieben werden, und nach Schritt (C) die in dem Code enthaltenen Daten zur Steuerung eines oder mehrerer der Schritte (D), (E) und (F) ausgelesen werden.

9. Verfahren nach Anspruch 8, **dadurch gekennzeichnet, dass** die in dem Code enthaltenen Daten einen oder mehrere der Schritte (D), (E) und (F) im Hinblick auf einen oder mehrere der nachfolgenden Prozessparameter steuern:
(i) Entwicklungstemperatur und/oder Entwicklungsdauer in Schritt (D);
(ii) Temperatur und/oder Entwicklungszeit in Schritt (E);
(iii) Intensität und/oder Belichtungszeit in Schritt (F);
(iv) Wellenlänge der elektromagnetischen Strahlung in Schritt (F);
(v) Transportgeschwindigkeit des Reliefvorläufers bzw. des Reliefs beim Durchlaufen eines oder mehrerer der Verfahrensschritte (D) bis (F).

10. Verfahren zur Herstellung von Reliefs ausgehend von einem Reliefvorläufer umfassend mindestens einen Träger und eine reliefbildende, gravierbare Schicht mit den Verfahrensschritten:
(A) Bereitstellung des Reliefvorläufers;
(B) Bereitstellung von Daten, welche den Typ des Reliefvorläufers kennzeichnen und/oder Prozessparameter für seine Verarbeitung enthalten;
(C) optional vollflächige Belichtung oder thermische Behandlung des Reliefvorläufers;
(D) Einschreiben eines dreidimensionalen Reliefs in die reliefbildende Schicht durch materialabtragende Methoden;
(E) optional Entfernung von Rückständen von der Reliefoberfläche;
(F) optional Nachbehandlung des erhaltenen Reliefs;
(G) optional Nachbelichtung des erhaltenen Reliefs mit elektromagnetischer Strahlung;
**dadurch gekennzeichnet, dass** die Daten, welche den Typ des Reliefvorläufers kennzeichnen und/oder Prozessparameter für dessen Verarbeitung enthalten, in Schritt (D) in Form eines Codes durch Lasergravur in die reliefbildende Schicht eingeschrieben werden, und nach Schritt (D) die in dem Code enthaltenen Daten zur Steuerung eines oder mehrerer der Schritte (E), (F) und (G) ausgelesen werden.

11. Verfahren nach Anspruch 10, **dadurch gekennzeichnet, dass** die in dem Code enthaltenen Daten einen oder mehrere der Schritte (E), (F) und (G) im Hinblick auf einen oder mehrere der nachfolgenden Prozessparameter steuern:
(i) Dauer und/oder Temperatur in Schritt (E);
(ii) Über- oder Unterdruck in Schritt (E);
(iii) Temperatur und/oder Dauer in Schritt (F);
(iv) Intensität und/oder Belichtungszeit in Schritt in Schritt (G);
(v) Wellenlänge der elektromagnetischen Strahlung in Schritt (G);
(vi) Transportgeschwindigkeit des Reliefs beim Durchlaufen eines oder mehrerer der Verfahrensschritte (E) bis (G).

12. Verfahren nach den Ansprüchen 1 bis 11, **dadurch gekennzeichnet, dass** das Auslesen der in dem Code enthaltenen Daten berührungslos erfolgt, und/oder dass die in dem Code enthaltenen Daten den Typ des Reliefvorläufers kennzeichnen und zugehörige Prozessparameter aus einer Datenbank ausgelesen werden.

13. Reliefstruktur mit Code, herstellbar nach dem Verfahren gemäß einem der Ansprüche 1-12.

14. System zur Kennzeichnung eines Reliefvorläufers oder eines Reliefs umfassend einen Träger und eine reliefbildende Schicht, wobei das System eingerichtet ist,
a) zur Bereitstellung von Daten, welche den Typ des Reliefvorläufers oder Reliefs kennzeichnen und/oder prozessrelevante Daten für dessen Verarbeitung enthalten, in Form mindestens eines Codes;
b) zum Einbringen des mindestens einen Codes in eine Maskenschicht und/ oder als Relief in die reliefbildende Schicht.

15. System nach Anspruch 14, wobei das System weiter eingerichtet ist, zum Auslesen der Daten.

16. System nach Anspruch 14 oder 15, wobei das System weiter eingerichtet ist, zur Prozesssteuerung auf Basis der Daten.

17. System nach Anspruch 16, wobei die Daten zu Prozessparametern der Prozesssteuerung zumindest eine der folgenden umfassen: Belichtungsbedingungen, Ablationsbedingungen, Temperaturbedingungen, Reinigungsbedingungen, Entwicklungsbedingungen, Trocknungsbedingungen, Lagerbedingungen, Gerätekonfigurationen und Einstellungen, Priorität im Prozessablauf und beliebige Kombinationen davon.
